# EUROPEAN PATENT APPLICATION

(11) **EP 4 207 322 A1**
(43) Date of publication of application: **05.07.2023**
(21) Application number: 22215155.7
(22) Date of filing: 20.12.2022
(51) Int. Cl.: H01L 33/62, H01L 25/075, H01L 33/44, H01L 33/50

(54) **DISPLAY DEVICE AND METHOD OF FABRICATING THE SAME**

(30) Priority: 31.12.2021 KR 20210193837
(71) Applicant: Samsung Display Co., Ltd., Yongin-si, Gyeonggi-do 17113 (KR)
(72) Inventor: KIM, Si, Kwang, 17113 Yongin-si (KR); KANG, Tae, Wook, 17113 Yongin-si (KR); LEE, Dong, Min, 17113 Yongin-si (KR)
(74) Representative: Marks & Clerk LLP

(57) **Abstract**

A display device includes: a substrate including a plurality of pixel areas each including an emission area and a non-emission area; and a pixel located in each of the pixel areas. The pixel includes: a light emitting element including a first end and a second end that face each other; a first electrode located on the first end of the light emitting element and electrically connected to the first end; and a second electrode located on the second end of the light emitting element and electrically connected to the second end. The first electrode and the second electrode include different conductive materials, and have different thicknesses.

## Description

### BACKGROUND

### 1. Field

Various embodiments of the present disclosure relate to a display device and a method of fabricating the display device.

### 2. Description of Related Art

Recently, as interest in information display increases, research and development on display devices have been continuously conducted.

### SUMMARY

Various embodiments of the present disclosure are directed to a display device that is improved in efficiency of a fabricating process, and are directed to a method of fabricating the display device.

A display device in accordance with one or more embodiments includes a substrate including a pixel area including an emission area and a non-emission area, and a pixel in the pixel area, and including a light emitting element including a first end and a second end that face each other, a first electrode on, and electrically connected to, the first end of the light emitting element, and a second electrode on, and electrically connected to, the second end of the light emitting element, and including a different conductive material than, and having a different thickness than, the first electrode.

The first electrode may include crystalline indium tin oxide, and the second electrode may include indium zinc oxide.

A thickness of the second electrode may be greater than a thickness of the first electrode.

The first electrode may include amorphous indium tin oxide before the second electrode is on the second end of the light emitting element.

The first electrode and the second electrode may be spaced from each other, and the light emitting element may be between the first electrode and the second electrode.

The first electrode may directly contact the first end of the light emitting element, and the second electrode may directly contact the second end of the light emitting element.

The first electrode and the second electrode may directly fix the light emitting element.

The first electrode may include indium zinc oxide, and the second electrode may include crystalline indium tin oxide.

A thickness of the first electrode may be greater than a thickness of the second electrode.

The pixel may include a first bank pattern and a second bank pattern above the substrate, and spaced from each other, a first insulating layer above the first and the second bank patterns, and configured to cover the first and the second bank patterns, a first bank on the first insulating layer in the non-emission area, and defining a first opening corresponding to the emission area, and a second opening spaced from the first opening, a first alignment electrode below the first insulating layer and over the first bank pattern in the emission area, and electrically connected with the first electrode, and a second alignment electrode below the first insulating layer and over the second bank pattern in the emission area, and electrically connected with the second electrode.

The first insulating layer may define a first contact hole that exposes a portion of the first alignment electrode, and a second contact hole that exposes a portion of the second alignment electrode, wherein the first electrode is electrically connected to the first alignment electrode through the first contact hole, and wherein the second electrode is electrically connected to the second alignment electrode through the second contact hole.

The pixel may further include an auxiliary insulating layer between the first electrode and the second electrode, wherein the auxiliary insulating layer is on the first electrode, covers the first electrode, and overlaps a portion of the second electrode.

The auxiliary insulating layer may fix the light emitting element.

The pixel may include a color conversion layer above the first electrode and the second electrode in the emission area, and configured to convert a first color of light emitted from the light emitting element to a second color of light, a second bank above the first bank in the non-emission area, and configured to at least partially enclose the color conversion layer, and a color filter above the color conversion layer, and configured to allow the second color of light to selectively pass therethrough.

The pixel may further include at least one transistor above the substrate, and electrically connected to the light emitting element.

The pixel may include a third alignment electrode between the first alignment electrode and the second alignment electrode, and spaced apart from the first and the second alignment electrodes, a fourth alignment electrode adjacent to the second alignment electrode, and spaced apart from the first to the third alignment electrodes, a first intermediate electrode spaced apart from the first and the second electrodes, and above the third alignment electrode, and a second intermediate electrode spaced apart from the first and the second electrodes, and above the fourth alignment electrode.

The light emitting element may include a first light emitting element electrically connected to the first electrode and the first intermediate electrode, and a second light emitting element electrically connected to the second intermediate electrode and the second electrode, wherein the first end of the first light emitting element is electrically connected to the first electrode, and the second end of the first light emitting element is electrically connected to the first intermediate electrode, and wherein the first end of the second light emitting element is electrically connected to the second intermediate electrode, and the second end of the second light emitting element is electrically connected to the second electrode.

A display device in accordance with one or more embodiments of the present disclosure may be fabricated by a method including forming, above a substrate, at least one pixel including an emission area and a non-emission area by forming, above the substrate in the emission area, a first alignment electrode and a second alignment electrode spaced apart from each other, forming a first insulating layer on the first and the second alignment electrodes, forming a first bank, which defines an opening corresponding to the emission area, on the first insulating layer in the non-emission area, aligning light emitting elements on the first insulating layer between the first alignment electrode and the second alignment electrode in the emission area, forming a first electrode electrically connected to respective first ends of the light emitting elements and the first alignment electrode, and forming a second electrode electrically connected to respective second ends of the light emitting elements and the second alignment electrode, the second electrode including a different conductive material than, and having a different thickness than, the first electrode.

Forming the first electrode may include applying a conductive layer including amorphous indium tin oxide to surfaces of the light emitting elements and the first insulating layer, forming a conductive pattern by locating a mask over the conductive layer and performing a photolithography process, the conductive pattern overlapping a portion of the first insulating layer and the respective first ends of the light emitting elements, and forming the first electrode including crystalline indium tin oxide by crystallizing the amorphous indium tin oxide by performing a heat treatment process on the conductive pattern.

The method may further include forming an auxiliary insulating layer covering the conductive pattern after forming the conductive pattern.

At least some of the above and other features of the invention are set out in the claims.

### BRIEF DESCRIPTION OF THE DRAWINGS

FIG. 1 is a perspective view schematically illustrating a light emitting element in accordance with one or more embodiments.
FIG. 2 is a schematic sectional view illustrating the light emitting element of FIG. 1.
FIG. 3 is a plan view schematically illustrating a display device in accordance with one or more embodiments.
FIG. 4 is a schematic circuit diagram illustrating an electrical connection relationship of components included in one of the pixels illustrated in FIG. 3.
FIG. 5 is a plan view schematically illustrating one of the pixels illustrated in FIG. 3.
FIG. 6 is a schematic sectional view taken along the line I-I' of FIG. 5.
FIGS. 7 to 11 are schematic sectional views taken along the line II-II' of FIG. 5.
FIG. 12 is a schematic sectional view taken along the line III-III' of FIG. 5.
FIGS. 13 to 20 are schematic sectional views for describing a method of fabricating the pixel illustrated in FIG. 7.
FIG. 21 is a schematic sectional view illustrating one or more embodiments of the method of fabricating the pixel illustrated in FIG. 19.
FIGS. 22 to 24 schematically illustrate a pixel in accordance with one or more embodiments, and are schematic sectional views corresponding to line I-I' of FIG. 5.
FIG. 25 is a circuit diagram illustrating one or more embodiments of an electrical connection relationship of components included in one of the pixels illustrated in FIG. 3.
FIG. 26 is a plan view schematically illustrating one of the pixels illustrated in FIG. 3.
FIG. 27 is a schematic sectional view taken along the line IV-IV' of FIG. 26.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in various different forms, and should not be construed as being limited to only the illustrated embodiments herein. Rather, these embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

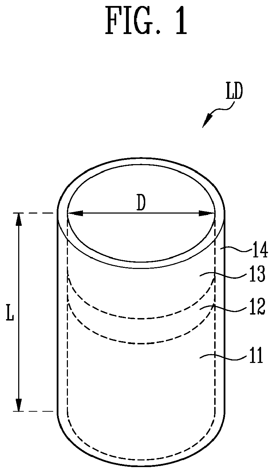

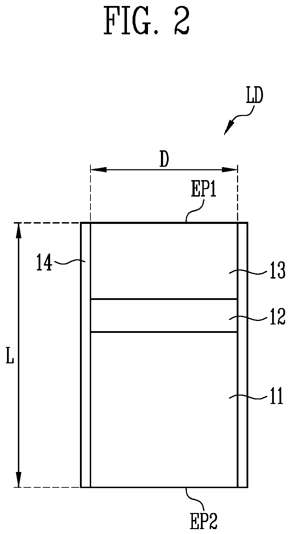

FIG. 1 is a perspective view schematically illustrating a light emitting element LD in accordance with one or more embodiments. FIG. 2 is a schematic sectional view illustrating the light emitting element LD of FIG. 1.

In one or more embodiments, the type and/or shape of the light emitting element LD is not limited to that of the embodiments illustrated in FIGS. 1 and 2.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or may be referred to as "stack pattern") formed by successively stacking the first semiconductor layer 11, the active layer 12, and the second semiconductor layer 13.

The light emitting element LD may be formed in a shape extending in one direction. If the direction in which the light emitting element LD extends is defined as a longitudinal direction, the light emitting element LD may have a first end EP1 and a second end EP2 with respect to the longitudinal direction. One semiconductor layer of the first semiconductor layer 11 and the second semiconductor layer 13 may be located on the first end EP1 of the light emitting element LD, and the other semiconductor layer of the first semiconductor layer 11 and the second semiconductor layer 13 may be located on the second end EP2 of the light emitting element LD. For example, the second semiconductor layer 13 may be located on the first end EP1 of the light emitting element LD, and the first semiconductor layer 11 may be located on the second end EP2 of the light emitting element LD.

The light emitting element LD may have various shapes. For example, as illustrated in FIG. 1, the light emitting element LD may have a rod-like shape, a bar-like shape, or a pillar-like shape that is long with respect to the longitudinal direction (or that has an aspect ratio greater than 1). Alternatively, the light emitting element LD may have a rod-like shape, a bar-like shape, or a pillar-like shape that is short with respect to the longitudinal direction (or that has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, for example, with a diameter D and/or a length L corresponding to a range from nano scale (or nanometer scale) to micro scale (or micrometer scale).

In the case that the light emitting element LD is long (for example, has an aspect ratio greater than 1) with respect to the longitudinal direction, the diameter D of the light emitting element LD may approximately range from about 0.5 µm to about 6 µm, and the length L thereof may approximately range from about 1 µm to about 10 µm. However, the diameter D and the length L of the light emitting element LD are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. For instance, the first semiconductor layer 11 may include an n-type semiconductor layer that includes any one semiconductor material of InAlGaN, GaN, AlGaN, InGaN, AIN, and InN and is doped with a first conductive dopant (or an n-type dopant) such as Si, Ge, or Sn. However, the constituent material of the first semiconductor layer 11 is not limited to thereto, and various other materials may be used to form the first semiconductor layer 11. The first semiconductor layer 11 may include, with respect to the longitudinal direction of the light emitting element LD, an upper surface that contacts the active layer 12, and a lower surface exposed to the outside.

The active layer 12 (or an emission layer) may be located on the first semiconductor layer 11, and may have a single or multiple quantum well structure. For example, in the case that the active layer 12 has a multiple quantum well structure, the active layer 12 may be formed by periodically and repeatedly stacking a barrier layer, a strain reinforcing layer, and a well layer, which are provided as one unit. The strain reinforcing layer may have a lattice constant that is less than that of the barrier layer so that strain, for example, compressive strain, to be applied to the well layer can be further reinforced. However, the structure of the active layer 12 is not limited to that of the one or more foregoing embodiments.

The active layer 12 may emit light having a wavelength ranging from about 400 nm to about 900 nm, and may have a double hetero structure. In one or more embodiments, a clad layer doped with a conductive dopant may be formed over or under the active layer 12 with respect to the longitudinal direction of the light emitting element LD. For example, the cladding layer may be formed of an AlGaN layer or an InAlGaN layer. In one or more embodiments, material such as AlGaN or InAlGaN may be used to form the active layer 12, and various other materials may be used to form the active layer 12. The active layer 12 may include a first surface that contacts the first semiconductor layer 11, and a second surface that contacts the second semiconductor layer 13.

If an electric field having a threshold voltage or more is applied between the opposite ends of the light emitting element LD, the light emitting element LD may emit light by coupling of electron-hole pairs in the active layer 12. Because light emission of the light emitting element LD can be controlled based on the foregoing principle, the light emitting element LD may be used as a light source (a light emitting source) of various light emitting devices as well as a pixel of a display device.

The second semiconductor layer 13 may be located on the second surface of the active layer 12, and may include a semiconductor layer having a type that is different from that of the first semiconductor layer 11. For example, the second semiconductor layer 13 may include at least one p-type semiconductor layer. For instance, the second semiconductor layer 13 may include a p-type semiconductor layer that includes any one semiconductor material of InAlGaN, GaN, AlGaN, InGaN, AIN, and InN, and may be doped with a second conductive dopant (or a p-type dopant) such as Mg, Zn, Ca, Sr, or Ba. However, the material for forming the second semiconductor layer 13 is not limited thereto, and various other materials may be used to form the second semiconductor layer 13. The second semiconductor layer 13 may include, with regard to the longitudinal direction of the light emitting element LD, a lower surface that contacts the second surface of the active layer 12, and an upper surface exposed to the outside.

In one or more embodiments, the first semiconductor layer 11 and the second semiconductor layer 13 may have different thicknesses with respect to the longitudinal direction of the light emitting element LD. For example, the first semiconductor layer 11 may have a thickness that is greater than that of the second semiconductor layer 13 with respect to the longitudinal direction of the light emitting element LD. Hence, the active layer 12 of the light emitting element LD may be located at a position closer to the upper surface of the second semiconductor layer 13 than to the lower surface of the first semiconductor layer 11.

Although each the first semiconductor layer 11 and the second semiconductor layer 13 is formed of a single layer, the present disclosure is not limited thereto. In one or more embodiments, depending on the material of the active layer 12, the first semiconductor layer 11, and the second semiconductor layer 13, each may further include one or more layers, for example, a clad layer and/or a tensile strain barrier reducing (TSBR) layer. The TSBR layer may be a strain relief layer of which a lattice structure is located between other semiconductor layers so that the strain relief layer can function as a buffer layer to reduce a difference in lattice constant. Although the TSBR layer may be formed of a p-type semiconductor layer such as p-GalnP, p-AllnP, or p-AlGalnP, the present disclosure is not limited thereto.

In one or more embodiments, the light emitting element LD may further include a contact electrode (hereinafter referred to as "first contact electrode") located over the second semiconductor layer 13, as well as including the first semiconductor layer 11, the active layer 12, and the second semiconductor layer 13. Furthermore, in one or more embodiments, the light emitting element LD may further include another contact electrode (hereinafter referred to as "second contact electrode") located on one end of the first semiconductor layer 11.

Each of the first and second contact electrodes may be an ohmic contact electrode, but the present disclosure is not limited thereto. In one or more embodiments, each of the first and second contact electrodes may be a Schottky contact electrode. The first and second contact electrodes may include conductive material. For example, the first and second contact electrodes may include opaque metal such as chromium (Cr), titanium (Ti), aluminium (Al), gold (Au), nickel (Ni), and oxides or alloys thereof, which are used alone or in combination, but the present disclosure is not limited thereto. In one or more embodiments, the first and second contact electrodes may also include transparent conductive oxides, such as indium tin oxide (ITO), indium zinc oxide (IZO), zinc oxide (ZnOₓ), indium gallium zinc oxide (IGZO), and indium tin zinc oxide (ITZO). Here, the zinc oxide (ZnOₓ) may be zinc oxide (ZnO) and/or zinc peroxide (ZnO₂).

Materials included in the first and second contact electrodes may be equal to or different from each other. The first and second contact electrodes may be substantially transparent or translucent. Therefore, light generated from the light emitting element LD may pass through the first and second contact electrodes and then may be emitted outside the light emitting element LD. In some embodiments, in the case that light generated from the light emitting element LD is emitted outside the light emitting element LD through an area other than the opposite ends of the light emitting element LD, rather than passing through the first and second contact electrodes, the first and second contact electrodes may include opaque metal.

In one or more embodiments, the light emitting element LD may further include an insulating film (or insulating layer) 14. However, in some embodiments, the insulating film 14 may be omitted, or may be provided to cover only some of the first semiconductor layer 11, the active layer 12, and the second semiconductor layer 13.

The insulating film 14 may prevent the active layer 12 from short-circuiting due to contacting conductive material other than the first and second semiconductor layers 11 and 13. Furthermore, the insulating film 14 may reduce or minimize a surface defect of the light emitting element LD, thus enhancing the lifetime and emission efficiency of the light emitting element LD. In the case that a plurality of light emitting elements LD are located in close contact with each other, the insulating film 14 may reduce or prevent the likelihood of an undesired short-circuit from occurring between the light emitting elements LD. The present disclosure is not limited to whether the insulating film 14 is provided or not, so long as the active layer 12 is able to be electrically insulated from external conductive material (e.g., to prevent short-circuiting therewith).

The insulating film 14 may be provided to enclose an overall outer circumferential surface of the emission stack including the first semiconductor layer 11, the active layer 12, and the second semiconductor layer 13.

Although the insulating film 14 has been described as enclosing the entirety of the respective outer circumferential surfaces of the first semiconductor layer 11, the active layer 12, and the second semiconductor layer 13 in the foregoing embodiments, the present disclosure is not limited thereto. In one or more embodiments, in the case that the light emitting element LD includes the first contact electrode, the insulating film 14 may enclose the entirety of the respective outer circumferential surfaces of the first semiconductor layer 11, the active layer 12, the second semiconductor layer 13, and the first contact electrode. In one or more embodiments, the insulating film 14 may not enclose the entirety of the outer circumferential surface of the first semiconductor layer 11, or may enclose only a portion of the outer circumferential surface of the first semiconductor layer 11 without enclosing the other portion of the outer circumferential surface of the first semiconductor layer 11. Furthermore, in one or more embodiments, in the case that the first contact electrode is located on one end (or an upper end) of the light emitting element LD, and the second contact electrode is located on a remaining end (or a lower end) of the light emitting element LD, the insulating film 14 may allow at least one area of each of the first and second contact electrodes to be exposed.

The insulating film 14 may include transparent insulating material. For example, the insulating film 14 may include one or more insulating materials selected from the group constituting of silicon oxide (SiOₓ), silicon nitride (SiNₓ), silicon oxynitride (SiOₓN_{y}), aluminium oxide (AlOₓ), titanium oxide (TiOₓ), hafnium oxide (HfOₓ), strontium titanate (SrTiOₓ), cobalt oxide (CoₓO_{y}), magnesium oxide (MgO), zinc oxide (ZnOₓ), ruthenium oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InₓO_{y}:H, niobium oxide (NbₓO_{y}), magnesium fluoride (MgFₓ), aluminium fluoride (AlFₓ), an alucone polymer film, titanium nitride (TiN), tantalum nitride (TaN), aluminium nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN). However, the present disclosure is not limited thereto, and various materials having insulation may be used as the material of the insulating layer 14.

The insulating layer 14 may be provided in the form of a single layer or in the form of multiple layers including double layers. For example, in the case that the insulating layer 14 is formed of a double layer structure including a first layer and a second layer that are successively stacked, the first layer and the second layer may be made of different materials (or substances) and may be formed through different processes. In one or more embodiments, the first layer and the second layer may include the same material, and may be formed through a successive process.

In one or more embodiments, the light emitting element LD may be implemented as a light emitting pattern (or a light emitting stack pattern) having a core-shell structure. In this case, the first semiconductor layer 11 may be located in a core of the light emitting element LD, for example, a central portion of the light emitting element LD. The active layer 12 may be provided and/or formed to enclose the outer circumferential surface of the first semiconductor layer 11. The second semiconductor layer 13 may be provided and/or formed to enclose the active layer 12. Furthermore, in one or more embodiments, the light emitting element LD may further include a contact electrode formed to enclose at least one side of the second semiconductor layer 13. In one or more embodiments, the light emitting element LD may further include an insulating layer 14 that is provided on the outer circumferential surface of the light emitting pattern having a core-shell structure, and that has transparent insulating material. The light emitting element LD implemented as the light emitting pattern having the core-shell structure may be manufactured in a growth manner.

The light emitting element LD may be employed as a light emitting source (or a light source) for various display devices. The light emitting element LD may be fabricated through a surface treatment process. For example, the light emitting element LD may be surface-treated so that, in the case that a plurality of light emitting elements LD are mixed with a fluidic solution (or solvent) and then supplied to each pixel area (for example, an emission area of each pixel or an emission area of each sub-pixel), the light emitting elements LD can be evenly distributed rather than unevenly aggregating in the solution.

An emission component (or a light emitting device) including the light emitting element LD described above may be used not only in a display device, but also in various types of electronic devices, each of which suitably uses a light source. For instance, in the case that a plurality of light emitting elements LD are located in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices, such as a lighting device, which suitably uses a light source.

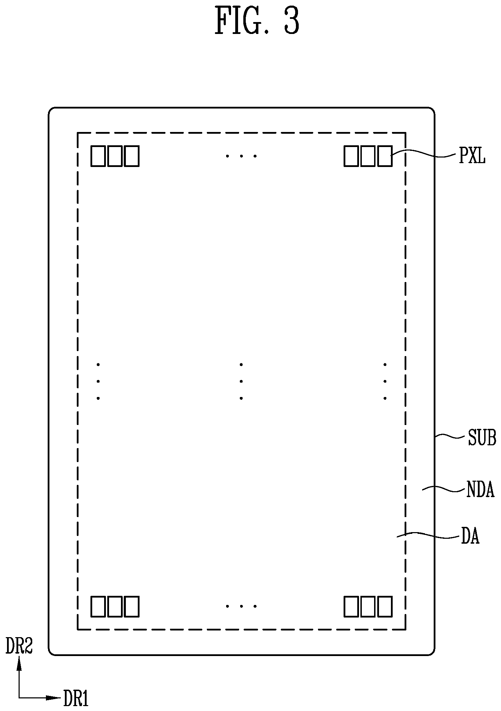

FIG. 3 is a plan view schematically illustrating a display device in accordance with one or more embodiments.

For convenience of description, FIG. 3 schematically illustrates the structure of the display device, focused on a display area DA on which an image is displayed.

If the display device is an electronic device having a display surface on at least one surface thereof, for example, a smartphone, a television, a tablet PC, a mobile phone, a video phone, an electronic reader, a desktop PC, a laptop PC, a netbook computer, a workstation, a server, a PDA, a portable multimedia player (PMP), an MP3 player, a medical appliance, a camera, or a wearable device, the present disclosure may be applied to the display device.

Referring to FIGS. 1 to 3, the display device may include a substrate SUB, a plurality of pixels PXL provided on the substrate SUB and each including at least one light emitting element LD, a driver provided on the substrate SUB and configured to drive the pixels PXL, and a line component provided to connect the pixels PXL with the driver.

The display device may be classified into a passive matrix type display device and an active matrix type display device, according to a method of driving the light emitting element LD. For example, in the case that the display device is implemented as an active matrix type display device, each of the pixels PXL may include a driving transistor configured to control the amount of current to be supplied to the light emitting element LD, and a switching transistor configured to transmit a data signal to the driving transistor.

The display device may be provided in various forms, for example, in the form of a rectangular plate having two pairs of parallel sides, but the present disclosure is not limited thereto. In the case that the display device is provided in the form of a rectangular plate, one pair of sides of the two pairs of sides may be longer than the other. For convenience of description, there is illustrated the case where the display device has a rectangular shape with a pair of long sides and a pair of short sides. A direction in which the long sides extend is indicated by a second direction DR2, and a direction in which the short sides extend is indicated by a first direction DR1. In the display device provided in a rectangular planar shape, each corner on which one long side and one short side contact (or meet) each other may have a rounded shape. However, the present disclosure is not limited thereto.

The substrate SUB may include a display area DA and a non-display area NDA.

The display area DA may be an area in which the pixels PXL for displaying an image are provided. The non-display area NDA may be an area in which the driver configured to drive the pixels PXL, and a portion of the line component for connecting the pixels PXL to the driver, are provided.

The non-display area NDA may be located adjacent to the display area DA. The non-display area NDA may be provided on at least one side of the display area DA. For example, the non-display area NDA may enclose the perimeter (or edges) of the display area DA. The line component connected to the pixels PXL, and the driver connected to the line component and configured to drive the pixels PXL, may be provided in the non-display area NDA.

The line component may electrically connect the driver with the pixels PXL. The line component may include a fanout line connected with signal lines, for example, a scan line, a data line, and an emission control line, which are connected to each pixel PXL to provide signals to the pixel PXL. Furthermore, in one or more embodiments, the line component may include a fanout line connected to signal lines, for example, a control line, and a sensing line, which are connected to each pixel PXL to compensate in real time for variation in electrical characteristics of the pixel PXL. In addition, the line component may include a fanout line connected with power lines that are configured to provide voltages to the respective pixels PXL, and connected to the respective pixels PXL.

The substrate SUB may include transparent insulating material to allow light transmission. The substrate SUB may be a rigid substrate or a flexible substrate.

One area on the substrate SUB may be provided as the display area DA in which the pixels PXL are located, and the other area thereof may be provided as the non-display area NDA. For example, the substrate SUB may include a display area DA including a plurality of pixel areas in which the respective pixels PXL are located, and a non-display area NDA located around the perimeter of the display area DA (or adjacent to the display area DA).

The pixels PXL may be provided in the display area DA on the substrate SUB. In one or more embodiments, the pixels PXL may be arranged in the display area DA in a stripe arrangement manner or the like, but the present disclosure is not limited thereto.

Each of the pixels PXL may include at least one or more light emitting elements LD configured to be driven in response to a corresponding scan signal and a corresponding data signal. The light emitting element LD may have a small size ranging from the nano scale (or the nanometer scale) to the micro scale (or the micrometer scale), and may be connected in parallel to light emitting elements LD located adjacent thereto, but the present disclosure is not limited thereto. The light emitting element LD may form a light source of each pixel PXL.

Each of the pixels PXL may include at least one light source, for example, the light emitting element LD illustrated in FIGS. 1 and 2, which is driven by a signal (for example, a scan signal and a data signal) and/or a power supply (for example, a first driving power supply and a second driving power supply). However, in one or more embodiments, the type of the light emitting element LD that may be used as a light source of each pixel PXL is not limited thereto.

The driver may supply a signal and a power voltage to each of the pixels PXL through the line component, and thus may control the operation of the pixel PXL.

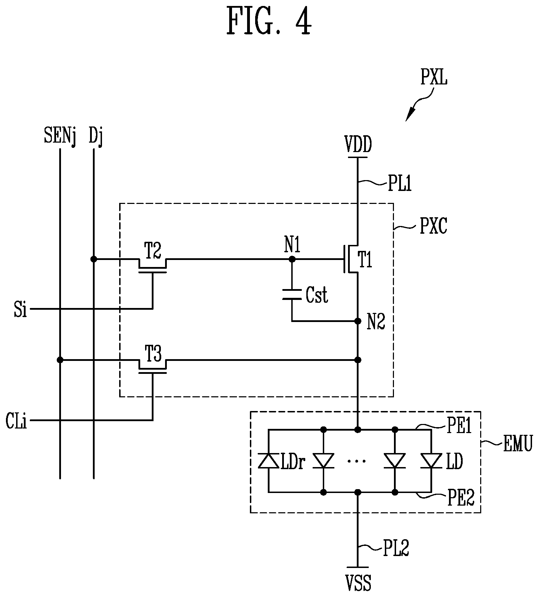

FIG. 4 is a schematic circuit diagram illustrating an electrical connection relationship of components included in each pixel PXL illustrated in FIG. 3.

For example, FIG. 4 illustrates the electrical connection relationship of components included in the pixel PXL that may be employed in an active matrix type display device in accordance with various embodiments. However, the types of the components included in the pixel PXL that can be applied to one or more embodiments are not limited thereto.

Referring to FIGS. 1 to 4, the pixel PXL may include an emission part EMU (or an emission unit) configured to generate light having a luminance corresponding to a data signal. Furthermore, the pixel PXL may selectively further include a pixel circuit PXC configured to drive the emission part EMU.

In one or more embodiments, the emission part EMU may include a plurality of light emitting elements LD connected in parallel between a first power line PL1 that is connected to a first driving power supply VDD, and to which a voltage of the first driving power supply VDD is applied, and a second power line PL2 that is connected to a second driving power supply VSS, and to which a voltage of the second driving power supply VSS is applied. For example, the emission part EMU may include a first pixel electrode (or a first electrode) PE1 connected to the first driving power supply VDD via the pixel circuit PXC and the first power line PL1, a second pixel electrode (or a second electrode) PE2 connected to the second driving power supply VSS by the second power line PL2, and a plurality of light emitting elements LD connected in parallel to each other in the same direction between the first and second pixel electrodes PE1 and PE2. In one or more embodiments, the first pixel electrode PE1 may be an anode, and the second pixel electrode PE2 may be a cathode.

Each of the light emitting elements LD included in the emission part EMU may include one end (or the first end EP1) connected to the first driving power supply VDD by the first pixel electrode PE1, and a remaining end (or the second end EP2) connected to the second driving power supply VSS by the second pixel electrode PE2. The first driving power supply VDD and the second driving power supply VSS may have different potentials. For example, the first driving power supply VDD may be set as a high-potential power supply, and the second driving power supply VSS may be set as a low-potential power supply. Here, a difference in potential between the first and second driving power supplies VDD and VSS may be set to a value equal to or greater than a threshold voltage of the light emitting elements LD during an emission period of the pixel PXL.

As described above, the light emitting elements LD that are connected in parallel to each other in the same direction (for example, in a forward direction) between the first pixel electrode PE1 and the second pixel electrode PE2 to which the voltages of the different power supplies are supplied may form respective valid light sources.

The light emitting elements LD of the emission part EMU may emit light having a luminance corresponding to driving current supplied thereto through the pixel circuit PXC. For example, during each frame period, driving current that corresponds to a grayscale value of a corresponding frame data of the pixel circuit PXC may be supplied to the emission part EMU. The driving current supplied to the emission part EMU may be divided into parts that flow into the respective light emitting elements LD. Hence, each of the light emitting elements LD may emit light having a luminance corresponding to current applied thereto, so that the emission part EMU may emit light having a luminance corresponding to the driving current.

Although there has been described one or more embodiments in which the opposite ends EP1 and EP2 of the light emitting elements LD are connected in the same direction between the first and second driving power supplies VDD and VSS, the present disclosure is not limited thereto. In one or more embodiments, the emission part EMU may further include at least one invalid light source, for example, a reverse light emitting element LDr, as well as including the light emitting elements LD that form the respective valid light sources. The reverse light emitting element LDr, along with the light emitting elements LD that form the valid light sources, may be connected in parallel to each other between the first and second pixel electrodes PE1 and PE2. Here, the reverse light emitting element LDr may be connected between the first and second pixel electrodes PE1 and PE2 in a direction that is opposite to that of the light emitting elements LD. Even if a certain driving voltage (for example, a forward driving voltage) is applied between the first and second pixel electrodes PE1 and PE2, the reverse light emitting element LDr remains disabled. Hence, current substantially does not flow through the reverse light emitting element LDr.

The pixel circuit PXC may be connected to a scan line Si and a data line Dj of the pixel PXL. The pixel circuit PXC may be connected to a control line CLi and a sensing line SENj of the pixel PXL. For example, in the case that the pixel PXL is located on an i-th row and a j-th column of the display area DA, the pixel circuit PXC of the pixel PXL may be connected to an i-th scan line Si, a j-th data line Dj, an i-th control line CLi, and a j-th sensing line SENj of the display area DA.

The pixel circuit PXC may include first to third transistors T1 to T3, and a storage capacitor Cst.

The first transistor T1 may be a driving transistor configured to control driving current to be applied to the emission part EMU, and may be connected between the first driving power supply VDD and the emission part EMU. In detail, a first terminal of the first transistor T1 may be connected to the first driving power supply VDD by the first power line PL1. A second terminal of the first transistor T1 may be connected to a second node N2. A gate electrode of the first transistor T1 may be connected to a first node N1. The first transistor T1 may control, in response to a voltage applied to the first node N1, the amount of driving current to be applied from the first driving power supply VDD to the emission part EMU by the second node N2. In one or more embodiments, the first terminal of the first transistor T1 may be a drain electrode, and the second terminal of the first transistor T1 may be a source electrode, and the present disclosure is not limited thereto. In one or more embodiments, the first terminal may be a source electrode, and the second terminal may be a drain electrode.

The second transistor T2 may be a switching transistor that selects a pixel PXL in response to a scan signal and that activates the pixel PXL, and may be connected between the data line Dj and the first node N1. A first terminal of the second transistor T2 may be connected to the data line Dj. A second terminal of the second transistor T2 may be connected to the first node N1. A gate electrode of the second transistor T2 may be connected to the scan line Si. The first terminal and the second terminal of the second transistor T2 are different terminals, and, for example, if the first terminal is a drain electrode, the second terminal is a source electrode.

In the case that a scan signal having a gate-on voltage (for example, a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are connected to each other. The second transistor T2 may transmit a data signal to the gate electrode of the first transistor T1.

The third transistor T3 may obtain a sensing signal through the sensing line SENj by connecting the first transistor T1 to the sensing line SENj, and may detect, using the sensing signal, characteristics of the pixel PXL such as a threshold voltage of the first transistor T1. Information about the characteristics of the pixel PXL may be used to convert image data such that a deviation in respective characteristics between pixels PXL can be compensated for. A second terminal of the third transistor T3 may be connected to the second terminal of the first transistor T1. A first terminal of the third transistor T3 may be connected to the sensing line SENj. A gate electrode of the third transistor T3 may be connected to the control line CLi. Furthermore, the first terminal of the third transistor T3 may be connected to an initialization power supply. The third transistor T3 may be an initialization transistor configured to initialize the second node N2, and may be turned on in the case that a sensing control signal is supplied thereto from the control line CLi, so that the voltage of the initialization power supply can be transmitted to the second node N2. Hence, a second storage electrode of the storage capacitor Cst connected to the second node N2 may be initialized.

A first storage electrode of the storage capacitor Cst may be connected to the first node N1. A second storage electrode of the storage capacitor Cst may be connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

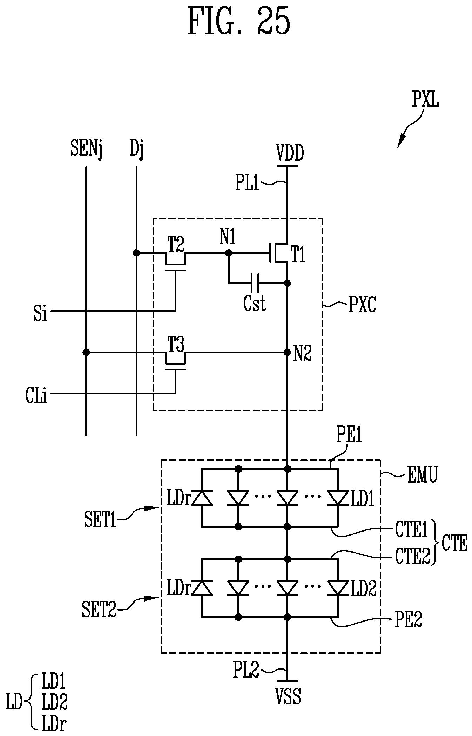

Although FIG. 4 illustrates one or more embodiments in which all of the light emitting elements LD that form the emission part EMU are connected in parallel to each other, the present disclosure is not limited thereto. In one or more embodiments, the emission part EMU may include at least one serial set (or stage) including a plurality of light emitting elements LD connected in parallel to each other. For example, the emission part EMU may be formed of a serial/parallel combination structure. One or more embodiments in which the emission part EMU is formed of a serial/parallel combination structure will be described below with reference to FIG. 25.

Although FIG. 4 illustrates one or more embodiments where all of the first, second, and third transistors T1, T2, and T3 included in the pixel circuit PXC are formed of N-type transistors, the present disclosure is not limited thereto. For example, at least one of the first, second, and third transistors T1, T2, and T3 may be changed to a P-type transistor. Furthermore, although FIG. 4 illustrates one or more embodiments where the emission part EMU is connected between the pixel circuit PXC and the second driving power supply VSS, the emission part EMU may be connected between the first driving power supply VDD and the pixel circuit PXC.

The structure of the pixel circuit PXC may be changed in various ways. For example, the pixel circuit PXC may further include at least one transistor element, such as a transistor element configured to initialize the first node N1, and/or a transistor element configured to control an emission time of the light emitting elements LD, or other circuit elements, such as a boosting capacitor for boosting the voltage of the first node N1.

The structure of the pixel PXL to which one or more embodiments may be applied is not limited to the embodiments illustrated in FIG. 4, and the pixel PXL may have various structures. For example, the pixel PXL may be configured inside a passive light emitting display device, or the like. In this case, the pixel circuit PXC may be omitted, and the opposite ends of the light emitting elements LD included in the emission part EMU may be directly connected to the scan line Si, the data line Dj, the first power line PL1 to which a voltage of the first driving power supply VDD is to be applied, the second power line PL2 to which a voltage of the second driving power supply VSS is to be applied, a control line CLi, and/or the like.

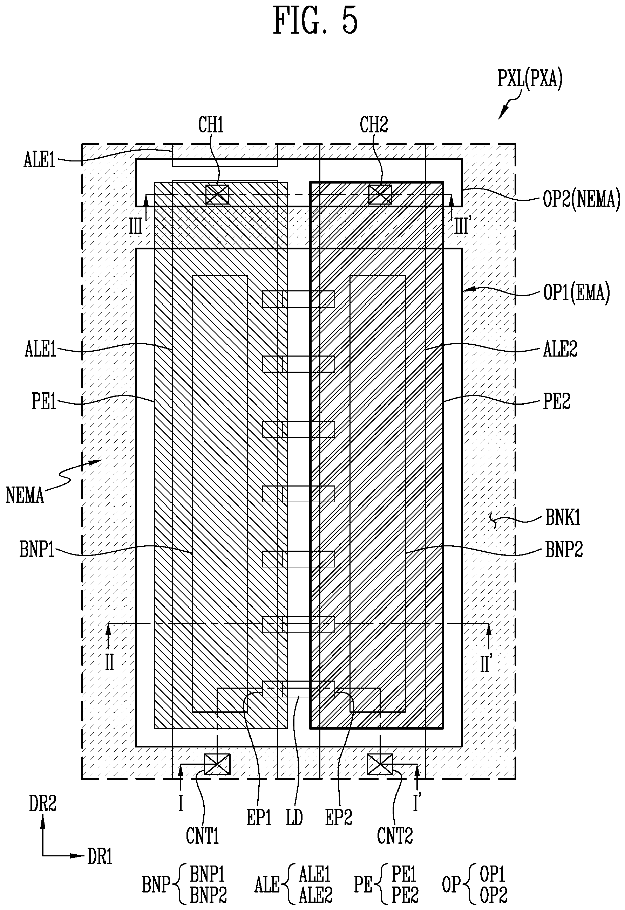

FIG. 5 is a plan view schematically illustrating each pixel PXL illustrated in FIG. 3.

In FIG. 5, for convenience of description, provides an illustration of the transistors electrically connected to the light emitting elements LD, while the signal lines electrically connected to the transistors are omitted.

In FIG. 5, for convenience of description, a horizontal direction in a plan view is indicated by a first direction DR1, and a vertical direction in a plan view is indicated by a second direction DR2.

In the following one or more embodiments, not only the components included in the pixel PXL illustrated in FIG. 5, but also an area in which the components are provided (or located) may be embraced in the definition of the term "pixel PXL".

Referring to FIGS. 1 to 5, the pixel PXL may be located in a pixel area PXA provided (or defined) on the substrate SUB. The pixel area PXA may include an emission area EMA and a non-emission area NEMA.

The pixel PXL may include a first bank BNK1 located in the non-emission area NEMA, and light emitting elements LD located in the emission area EMA.

The first bank BNK1 may be a structure for defining (or partitioning) the respective pixel areas PXA (or the respective emission areas EMA) of the pixel PXL and pixels PXL adjacent thereto and, for example, may be a pixel defining layer.

In one or more embodiments, the first bank BNK1 may be a pixel defining layer or a dam structure for defining each emission area EMA to which the light emitting elements LD are to be supplied during a process of supplying (or inputting) the light emitting elements LD to the pixel PXL. For example, because the emission area EMA of the pixel PXL is defined by the first bank BNK1, a mixed solution (for example, ink) including a target amount and/or type of light emitting elements LD may be supplied (or input) to the emission area EMA. In one or more embodiments, during a process of supplying a color conversion layer to the pixel PXL, the first bank BNK1 may be a pixel defining layer that ultimately defines each emission area EMA to which the color conversion layer is to be supplied.

In one or more embodiments, the first bank BNK1 may include at least one light block material and/or reflective material (or scattering material), thus reducing or preventing light leakage in which light (or rays) leaks between the pixel PXL and the pixels PXL adjacent thereto. In one or more embodiments, the first bank BNK1 may include transparent material (or substance). The transparent material may include, for example, polyamides resin, polyimides resin, etc., but the present disclosure is not limited thereto. In one or more embodiments, to enhance the efficiency of light emitted from the pixel PXL, a separate reflective material layer may be provided and/or formed on the first bank BNK1.

The first bank BNK1 may include, in the pixel area PXA, at least one opening OP that exposes components located thereunder. For example, the first bank BNK1 may include a first opening OP1 and a second opening OP2 that expose components located under (e.g., at a layer beneath) the first bank BNK1 in the pixel area PXA. In one or more embodiments, the emission area EMA of the pixel PXL and the first opening OP1 of the first bank BNK1 may correspond to each other.

In the pixel area PXA, the second opening OP2 may be located at a position spaced apart from the first opening OP1, and may be located adjacent to one side of the pixel area PXA, for example, an upper side of the pixel area PXA. In one or more embodiments, the second opening OP2 may be an electrode separation area where at least one alignment electrode ALE is separated from at least one alignment electrode ALE provided in pixels PXL adjacent thereto in the second direction DR2.

The pixel PXL may include pixel electrodes PE provided in at least the emission area EMA, light emitting elements LD electrically connected to the pixel electrodes PE, and bank patterns BNP and alignment electrodes ALE that are provided at positions corresponding to the pixel electrodes PE. For example, the pixel PXL may include first and second pixel electrodes PE1 and PE2, light emitting elements LD, first and second alignment electrodes ALE1 and ALE2, and first and second bank patterns BNP1 and BNP2, which are provided in at least the emission area EMA. The pixel electrodes PE and/or the alignment electrodes ALE each may be changed in number, shape, size, arrangement structure, etc. in various ways depending on the structure of the pixel PXL (for example, the emission part EMU).

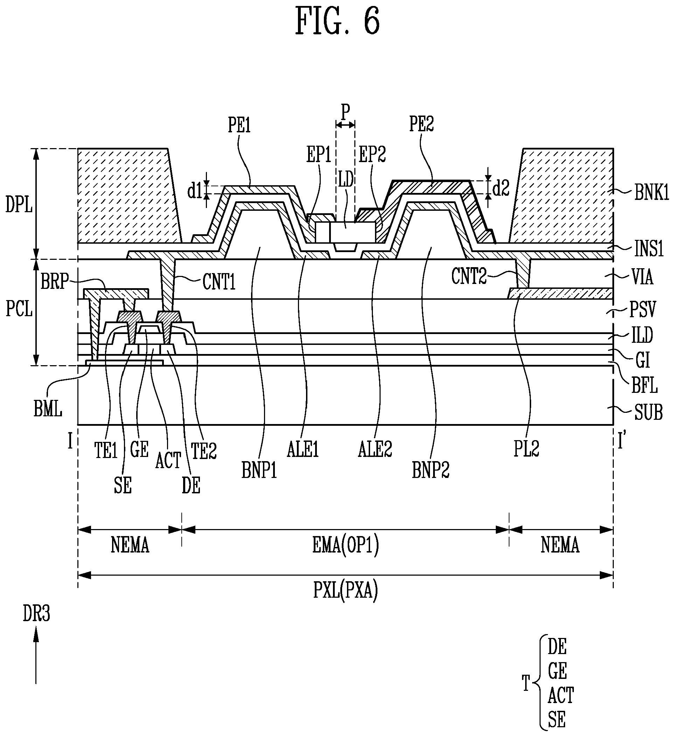

In one or more embodiments, based on one surface of the substrate SUB on which the pixel PXL is provided, the bank patterns BNP, the alignment electrodes ALE, the light emitting elements LD, and the pixel electrodes PE may be provided in the order listed, but the present disclosure is not limited thereto. In one or more embodiments, the positions and formation sequence of electrode patterns that form the pixel PXL (or the emission part EMU) may be changed in various ways. Description of a stacked structure of the pixel PXL will be described below with reference to FIGS. 6 to 12.

The bank patterns BNP may be provided in at least the emission area EMA, and may be spaced apart from each other with respect to the first direction DR1 in the emission area EMA, and each may extend in the second direction DR2. The bank pattern BNP may include a first bank pattern BNP1 and a second bank pattern BNP2 that are arranged at positions spaced apart from each other in the first direction DR1.

Each bank pattern BNP (referred also to as "wall pattern," "protrusion pattern," "support pattern," or "wall structure") may have a uniform width in the emission area EMA. For example, each of the first and second bank patterns BNP1 and BNP2 may have a bar-like shape having a certain width with respect to an extension direction thereof in the emission area EMA, in a plan view, but the present disclosure is not limited thereto.

The bank pattern BNP may support each of the first and second alignment electrodes ALE1 and ALE2 to change a surface profile (or a surface shape) of each of the first and second alignment electrodes ALE1 and ALE2 so that light emitted from the light emitting elements LD can be guided in the image display direction of the display device.

The bank patterns BNP may have the same width or different widths. For example, the first and second bank patterns BNP1 and BNP2 may have the same width or different widths with respect to the first direction DR1 in at least the emission area EMA.

Each of the first and second bank patterns BNP1 and BNP2 may partially overlap at least one alignment electrode ALE in at least the emission area EMA. For example, the first bank pattern BNP1 may be located under the first alignment electrode ALE1 to overlap a corresponding area of the first alignment electrode ALE1. The second bank pattern BNP2 may be located under the second alignment electrode ALE2 to overlap a corresponding area of the second alignment electrode ALE2. The bank pattern BNP along with the alignment electrode ALE may function as a structure for accurately defining (or providing) an alignment position of the light emitting elements LD in the emission area EMA of the pixel PXL.

Because the bank patterns BNP are provided under a respective area of each of the alignment electrodes ALE, the corresponding area of each of the alignment electrodes ALE may protrude in an upward direction of the pixel PXL in the areas where the bank patterns BNP are formed. In this way, the bank patterns BNP, each of which being a wall structure, may be formed around the light emitting elements LD. For example, the wall structures may be formed in the emission area EMA, and may face the first and second ends EP1 and EP2 of the light emitting elements LD.

In one or more embodiments, in the case that the bank patterns BNP and/or the alignment electrodes ALE include reflective material, a reflective wall structure may be formed around the light emitting elements LD. Hence, light emitted from the light emitting elements LD may be oriented in an upward direction of the pixel PXL (for example, in an image display direction of the display device), so that the light efficiency of the pixel PXL may be further improved.

The alignment electrodes ALE may be located in at least the emission area EMA, and may be spaced apart from each other with respect to the first direction DR1 in the emission area EMA, and each may extend in the second direction DR2. The alignment electrodes ALE may include the first alignment electrode ALE1 and the second alignment electrode ALE2 that are spaced apart from each other in the first direction DR1.

At least one of the first and second alignment electrodes ALE1 and ALE2 may be separated from other electrodes (for example, an alignment electrode ALE provided in each of pixels PXL adjacent thereto in the second direction DR2) in the second opening OP2 (or the electrode separation area) of the first bank BNK1 after the light emitting elements LD are supplied to, and aligned in, the pixel area PXA during a process of fabricating the pixel PXL (or the display device). For example, one end of the first alignment electrode ALE1 may be separated, in the second opening OP2, from the first alignment electrode ALE1 of the pixel PXL that is located above the corresponding pixel PXL in the second direction DR2.

The first alignment electrode ALE1 may be electrically connected with the first transistor T1 described with reference to FIG. 4 by a first contactor CNT1. The second alignment electrode ALE2 may be electrically connected with the second power line PL2 (or the second driving power supply VSS) described with reference to FIG. 4 by a second contactor CNT2.

In one or more embodiments, the first contactor CNT1 and the second contactor CNT2 may be located in the non-emission area NEMA and may overlap the first bank BNK1. The present disclosure is not limited thereto. In one or more embodiments, the first and second contactors CNT1 and CNT2 may be located in the emission area EMA or in the second opening OP2 of the first bank BNK1.

The first alignment electrode ALE1 may be electrically connected to the first pixel electrode PE1 through a first contact hole CH1 in the second opening OP2 of the first bank BNK1. The second alignment electrode ALE2 may be electrically connected to the second pixel electrode PE2 through a second contact hole CH2 in the second opening OP2 of the first bank BNK1.

In one or more embodiments, each of the first alignment electrode ALE1 and the second alignment electrode ALE2 may be supplied with a signal (or an alignment signal) from an alignment pad located in the non-display area NDA during the operation of aligning the light emitting elements LD. For example, the first alignment electrode ALE1 may be supplied with a first alignment signal (or a first alignment voltage) from a first alignment pad. The second alignment electrode ALE2 may be supplied with a second alignment signal (or a second alignment voltage) from a second alignment pad. The above-mentioned first and second alignment signals may be signals each having a voltage difference and/or a phase difference enabling the light emitting elements LD to be aligned between the first and second alignment electrodes ALE1 and ALE2. At least one of the first and second alignment signals may be an AC signal, but the present disclosure is not limited thereto.

Each alignment electrode ALE may have a bar-like shape (or an "I" shape) having a uniform width with respect to the second direction DR2, but the present disclosure is not limited thereto. In one or more embodiments, each alignment electrode ALE may or may not have a bent portion in the non-emission area NEMA and/or the second opening OP2 of the first bank BNK1 that is an electrode separation area, and the shape and/or size of the alignment electrode ALE in areas other than the emission area EMA may be changed in various ways rather than being particularly limited.

Although at least two to several tens of light emitting elements LD may be aligned and/or provided in the emission area EMA (or the pixel area PXA), the number of light emitting elements LD is not limited thereto. In one or more embodiments, the number of light emitting elements LD aligned and/or provided in the emission area EMA (or the pixel area PXA) may be changed in various ways.

The light emitting elements LD may be located between the first alignment electrode ALE1 and the second alignment electrode ALE2. Each of the light emitting elements LD may be the light emitting element LD described with reference to FIG. 1. Each of the light emitting elements LD may include a first end EP1 (or one end) and a second end EP2 (or a remaining end) that are located on opposite ends thereof with respect to the longitudinal direction. In one or more embodiments, the second semiconductor layer 13 including a p-type semiconductor layer may be located on the first end EP1, and the first semiconductor layer 11 including an n-type semiconductor layer may be located on the second end EP2. The light emitting elements LD may be connected in parallel between the first alignment electrode ALE1 and the second alignment electrode ALE2.

Each of the light emitting elements LD may emit any one of color light and/or white light. Each of the light emitting elements LD may be aligned between the first alignment electrode ALE1 and the second alignment electrode ALE2 such that the longitudinal direction is substantially parallel to the first direction DR1. In one or more embodiments, the light emitting elements LD may be aligned between the first alignment electrode ALE1 and the second alignment electrode ALE2 such that at least some of the light emitting elements LD are not completely parallel to the first direction DR1. For example, some light emitting elements LD may be aligned to be inclined with respect to the first direction DR1 between the first alignment electrode ALE1 and the second alignment electrode ALE2. The light emitting elements LD may be provided in a diffused form in a solution (or ink) and then supplied (or input) to the pixel area PXA (or the emission area EMA).

The light emitting elements LD may be input (or supplied) to the pixel area PXA (or the emission area EMA) by an inkjet printing scheme, a slit coating scheme, or other various schemes. For example, the light emitting elements LD may be mixed with a volatile solvent and then input (or supplied) to the pixel area PXA by an inkjet printing scheme or a slit coating scheme. Here, if the first alignment electrode ALE1 and the second alignment electrode ALE2 are respectively supplied with corresponding alignment signals, an electric field may be formed between the first alignment electrode ALE1 and the second alignment electrode ALE2. Consequently, the light emitting elements LD may be aligned between the first alignment electrode ALE1 and the second alignment electrode ALE2. After the light emitting elements LD are aligned, the solvent may be removed by a volatilization scheme or other schemes. In this way, the light emitting elements LD may be reliably aligned between the first alignment electrode ALE1 and the second alignment electrode ALE2.

The pixel electrodes (or the electrodes) PE may be provided in at least the emission area EMA, and each may be provided at a position corresponding to at least one alignment electrode ALE and the light emitting element LD. For example, each pixel electrode PE may be formed on the corresponding alignment electrode ALE and the corresponding light emitting elements LD to overlap the corresponding alignment electrode ALE and the corresponding light emitting elements LD, and thus may be electrically connected to at least the light emitting elements LD.

The first pixel electrode (e.g., "first electrode" or "anode") PE1 may be formed on the first alignment electrode ALE1 and the respective first ends EP1 of the light emitting elements LD, and thus may be electrically connected to the respective first ends EP1 of the light emitting elements LD. Furthermore, the first pixel electrode PE1 may directly contact the first alignment electrode ALE1 through the first contact hole CH1 in at least the non-emission area NEMA, for example, the second opening OP2 of the first bank BNK1, and may be electrically and/or physically connected with the first alignment electrode ALE1. The first contact hole CH1 may be formed by removing a portion of at least one insulating layer located between the first pixel electrode PE1 and the first alignment electrode ALE1, and may expose a portion of the first alignment electrode ALE1.

Although the first contact hole CH1 that is a connection point (or a contact portion) between the first pixel electrode PE1 and the first alignment electrode ALE1 has been described as being located in the second opening OP2, the present disclosure is not limited thereto. In one or more embodiments, the connection point (or the contact point) between the first pixel electrode PE1 and the first alignment electrode ALE1 may be located in at least the emission area EMA.

The first transistor T1, the first alignment electrode ALE1, and the first pixel electrode PE1 may be electrically connected to each other through the first contactor CNT1 and the first contact hole CH1.

The first pixel electrode PE1 may have a bar-like shape extending in the second direction DR2, but the present disclosure is not limited thereto. In one or more embodiments, the shape of the first pixel electrode PE1 may be changed in various ways so long as the first pixel electrode PE1 can be electrically and/or physically reliably connected with the first ends EP1 of the light emitting elements LD. Furthermore, the shape of the first pixel electrode PE1 may be changed in various ways, considering the connection relationship with the first alignment electrode ALE1 located thereunder.

The second pixel electrode PE2 (referred also to as "second electrode" or "cathode") may be formed on the second alignment electrode ALE2 and the respective second ends EP2 of the light emitting elements LD, and thus may be electrically connected to the respective second ends EP2 of the light emitting elements LD. Furthermore, the second pixel electrode PE2 may directly contact the second alignment electrode ALE2 through the second contact hole CH2, and may be electrically and/or physically connected with the second alignment electrode ALE2. The second contact hole CH2 may be formed by removing a portion of at least one insulating layer located between the second pixel electrode PE2 and the second alignment electrode ALE2, and may expose a portion of the second alignment electrode ALE2. In one or more embodiments, the second contact hole CH2 that is a connection point (or a contact point) between the second pixel electrode PE2 and the second alignment electrode ALE2 may be located in the emission area EMA.

The second power line PL2, the second alignment electrode ALE2, and the second pixel electrode PE2 may be electrically connected to each other through the second contactor CNT2 and the second contact hole CH2.

The second pixel electrode PE2 may have a bar-like shape extending in the second direction DR2, but the present disclosure is not limited thereto. In one or more embodiments, the shape of the second pixel electrode PE2 may be changed in various ways so long as the second pixel electrode PE2 can be electrically and/or physically reliably connected with the second ends EP2 of the light emitting elements LD. Furthermore, the shape of the second pixel electrode PE2 may be changed in various ways, considering the connection relationship with the second alignment electrode ALE2 located thereunder.

The first pixel electrode PE1 and the second pixel electrode PE2 may be formed of various transparent conductive materials to reduce or minimize loss of light emitted from each of the light emitting elements LD. In one or more embodiments, the first pixel electrode PE1 and the second pixel electrode PE2 may be formed of different transparent conductive materials. For example, one of the first pixel electrode PE1 and the second pixel electrode PE2 may include crystalline indium tin oxide (ITO), and the other one of the first pixel electrode PE1 and the second pixel electrode PE2 may include indium zinc oxide (IZO).

The first pixel electrode PE1 and the second pixel electrode PE2 that are formed of different transparent conductive materials may have different thicknesses due to material properties. For example, in the case that the first pixel electrode PE1 includes crystalline indium tin oxide and the second pixel electrode PE2 includes indium zinc oxide, the second pixel electrode PE2 may be designed to be thicker than the first pixel electrode PE1. Detailed descriptions pertaining thereto will be made with reference to FIGS. 6 to 12.

Hereinafter, the stacked structure of the pixel PXL in accordance with the foregoing embodiments will be mainly described with reference to FIGS. 6 to 12.

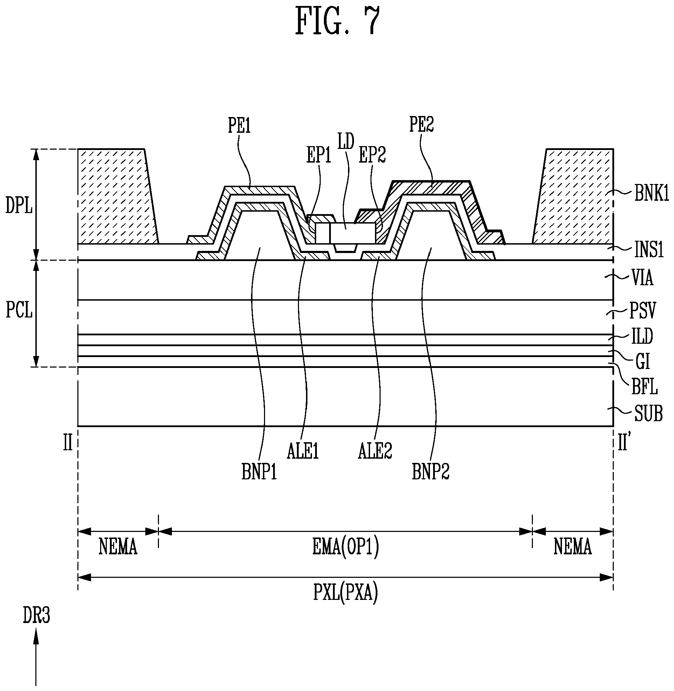

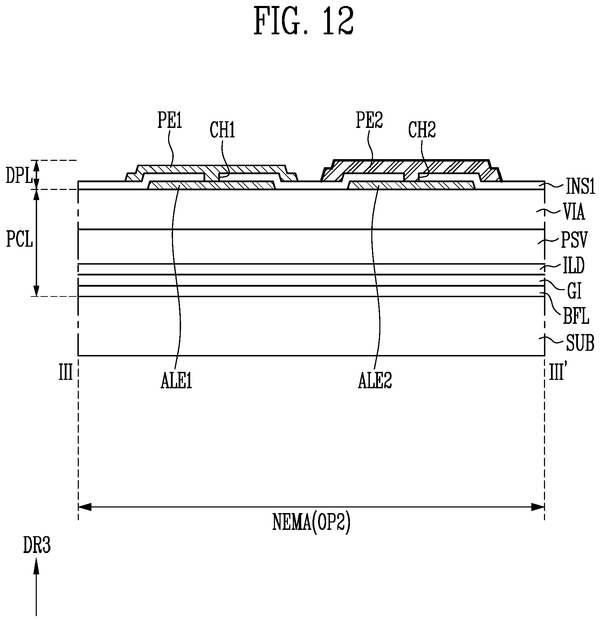

FIG. 6 is a schematic sectional view taken along the line I-I' of FIG. 5. FIGS. 7 to 11 are schematic sectional views taken along the line II-II' of FIG. 5. FIG. 12 is a schematic sectional diagram taken along the line III-III' of FIG. 5.

In the description of embodiments, "components are provided and/or formed on the same layer" may mean that the components are formed through the same process, and "components are provided and/or formed on different layers may mean that the components are formed through different respective processes.

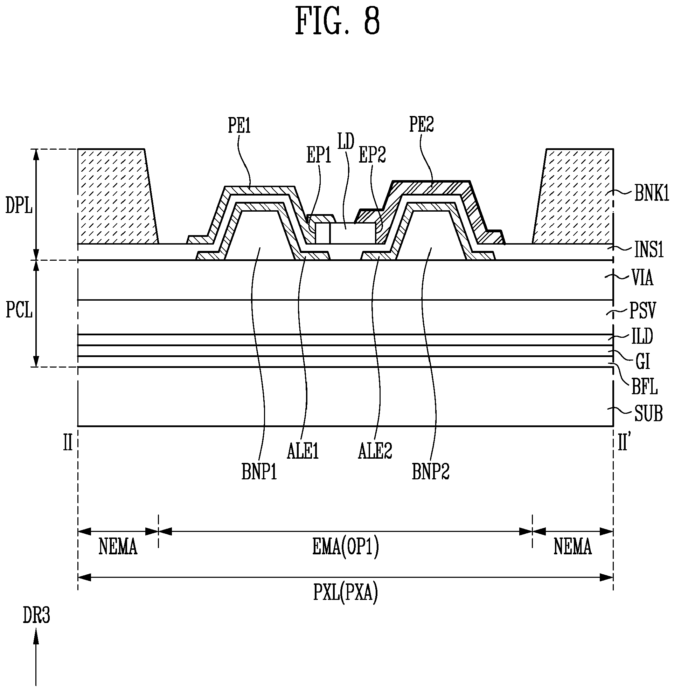

FIG. 8 illustrates a modification of the one or more embodiments corresponding to FIG. 7 with regard to a first insulating layer INS1 or the like.

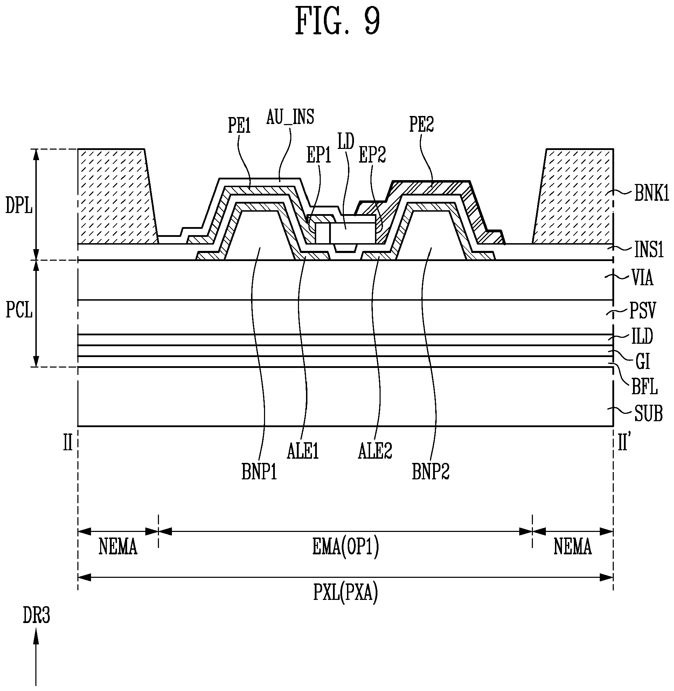

FIG. 9 illustrates a modification of the one or more embodiments corresponding to FIG. 7 with regard to an auxiliary insulating layer AU_INS or the like.

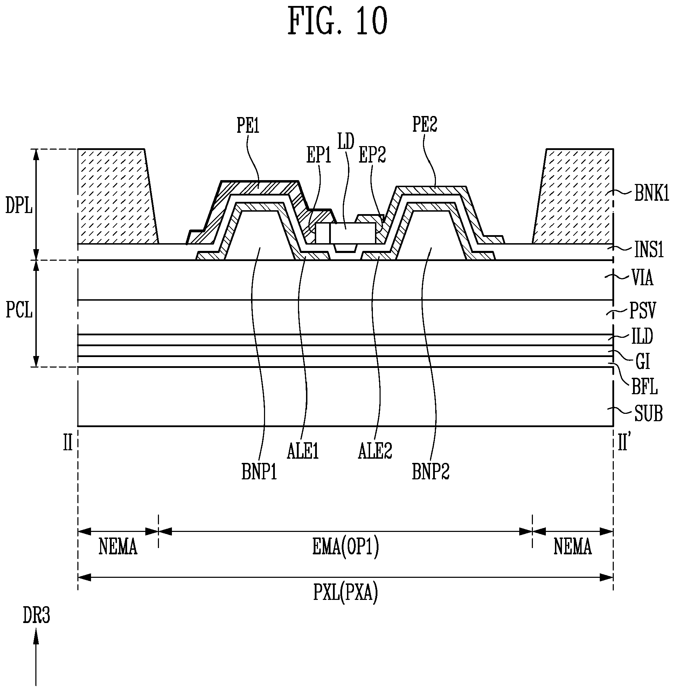

FIG. 10 illustrates a modification of the one or more embodiments corresponding to FIG. 7 with regard to the first and second pixel electrodes PE1 and PE2, or the like.

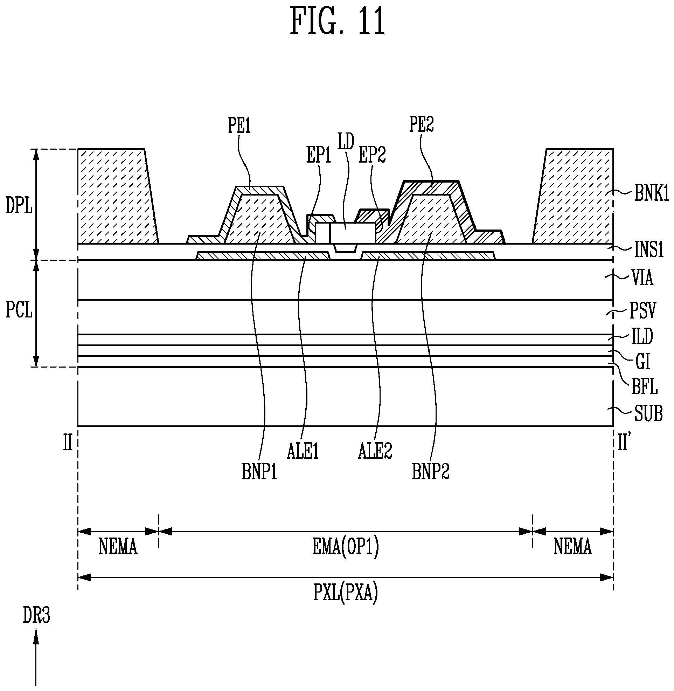

FIG. 11 illustrates a modification of the one or more embodiments corresponding to FIG. 7 with regard to the alignment electrodes ALE1 and ALE2, the bank patterns BNP1 and BNP2, and the like.

In FIGS. 6 to 12, a vertical direction (or a thickness direction of the substrate SUB) in a cross-sectional view is represented by a third direction DR3.

Referring to FIGS. 1 to 12, the pixel PXL may include a substrate SUB, a pixel circuit layer PCL, and a display element layer DPL.

The pixel circuit layer PCL and the display element layer DPL may be located above one surface of the substrate SUB and may overlap each other. For example, the display area DA of the substrate SUB may include the pixel circuit layer PCL located on the one surface of the substrate SUB, and the display element layer DPL located on the pixel circuit layer PCL. However, relative positions of the pixel circuit layer PCL and the display element layer DPL on the substrate SUB may be changed depending on embodiments. In the case that the pixel circuit layer PCL and the display element layer DPL are separated from each other as separate layers and overlap each other, layout space sufficient to form each of the pixel circuit PXC and the emission part EMU on a plane may be secured. In one or more embodiments, the pixel circuit layer PCL and the display element layer DPL may be located on the same plane without overlapping each other so that a display device having a reduced thickness can be embodied.

The substrate SUB may include transparent insulating material to allow light transmission. The substrate SUB may be a rigid substrate or a flexible substrate.

For example, the rigid substrate SUB may be one of a glass substrate, a quartz substrate, a glass ceramic substrate, and a crystalline glass substrate.

The flexible substrate SUB may be either a film substrate or a plastic substrate that includes polymer organic material. For example, the flexible substrate SUB may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

Circuit elements (for example, transistors T) for forming the pixel circuit PXC of the corresponding pixel PXL, and signal lines electrically connected to the circuit elements, may be located in each pixel area PXA of the pixel circuit layer PCL. Furthermore, in each pixel area PXA of the display element layer DPL, the bank patterns BNP, the alignment electrodes ALE, the light emitting elements LD, and/or the pixel electrodes PE that form the emission part EMU of the corresponding pixel PXL may be located.

The pixel circuit layer PCL may include at least one or more insulating layers as well as the circuit elements and the signal lines. For example, the pixel circuit layer PCL may include a buffer layer BFL, a gate insulating layer GI, an interlayer insulating layer ILD, a passivation layer PSV, and a via layer VIA that are successively stacked on the substrate SUB in the third direction DR3.

The buffer layer BFL may be provided and/or formed on the overall surface of the substrate SUB. The buffer layer BFL may reduce or prevent impurities from diffusing into a transistor T included in the pixel circuit PXC. The buffer layer BFL may be an inorganic insulating layer formed of inorganic material. The buffer layer BFL may include at least one of silicon nitride (SiNₓ), silicon oxide (SiOₓ), silicon oxynitride (SiOₓN_{y}), and metal oxide, such as aluminium oxide (AlOₓ). The buffer layer BFL may be provided in a single-layer structure or a multi-layer structure having at least two or more layers. In the case that the buffer layer BFL has a multi-layer structure, the respective layers may be formed of the same material or different materials. The buffer layer BFL may be omitted depending on the material of the substrate SUB or processing conditions.

The gate insulating layer GI may be located on the overall surface of the buffer layer BFL. The gate insulating layer GI may include the same material as that of the buffer layer BFL, or may include a suitable material of the materials exemplified as the constituent materials of the buffer layer BFL. The gate insulating layer GI may be an inorganic insulating layer including inorganic material.

The interlayer insulating layer ILD may be provided and/or formed on the overall surface of the gate insulating layer GI. The interlayer insulating layer ILD may include the same material as that of the gate insulating layer GI, or may include one or more materials selected from among the materials exemplified as the constituent material of the gate insulating layer GI.

The passivation layer PSV may be provided and/or formed on the overall surface of the interlayer insulating layer ILD. The passivation layer PSV may be formed of an inorganic layer (or an inorganic insulating layer) including inorganic material, or an organic layer (or an organic insulating layer) including organic material. The inorganic layer may include, for example, at least one of silicon oxide (SiOₓ), silicon nitride (SiNₓ), silicon oxynitride (SiOₓN_{y}), and metal oxide, such as aluminium oxide (AlOₓ). The organic layer may include, for example, at least one of polyacrylates resin, epoxy resin, phenolic resin, polyamides resin, polyimides rein, unsaturated polyesters resin, poly-phenylene ethers resin, poly-phenylene sulfides resin, and benzocyclobutene resin.

The passivation layer PSV may be partially open to include the first contactor CNT1 that exposes one area of one component of the pixel circuit PXC, for example, one area of a second connector TE2. Furthermore, in one or more embodiments, the passivation layer PSV may be partially open to expose areas of other components of the pixel circuit PXC, for example, one area of a first connector TE1 and one area of a bottom conductive pattern BML.

In one or more embodiments, the passivation layer PSV may have the same material as that of the interlayer insulating layer ILD, but the present disclosure is not limited thereto. The passivation layer PSV may be provided in a single-layer structure or a multi-layer structure having at least two or more layers.

The via layer VIA may be provided and/or formed on the overall surface of the passivation layer PSV. The via layer VIA may be formed of a single layer including an organic layer, or multiple layers having two or more layers. In one or more embodiments, the via layer VIA may be provided in a shape including an inorganic layer, and an organic layer located on the inorganic layer. In the case that the via layer VIA is formed of multiple layers having two or more layers, the organic layer included in the via layer VIA may be located on the uppermost layer of the via layer VIA. The via layer VIA may include at least one of polyacrylates resin, epoxy resin, phenolic resin, polyamides resin, polyimides rein, unsaturated polyesters resin, poly-phenylene ethers resin, poly-phenylene sulfides resin, and benzocyclobutene resin.

The via layer VIA may include a first contactor CNT1 corresponding to the first contactor CNT1 of the passivation layer PSV, and a second contactor CNT2 that exposes the second power line PL2. In one or more embodiments, the via layer VIA formed of an organic layer may be used as a planarization layer that mitigates a step difference caused by the components (for example, transistors T, power lines, a bridge pattern BRP, etc.) located under the via layer VIA in the pixel circuit layer PCL.

The pixel circuit layer PCL may include at least one or more conductive layers located between the above-mentioned insulating layers. For example, the pixel circuit layer PCL may include a first conductive layer located between the substrate SUB and the buffer layer BFL, a second conductive layer located on the gate insulating layer GI, a third conductive layer located on the interlayer insulating layer ILD, and a fourth conductive layer located on the passivation layer PSV.

The first conductive layer may have a single-layer structure formed of one or a combination selected from the group consisting of copper (Cu), molybdenum (Mo), tungsten (W), aluminium neodymium (AINd), titanium (Ti), aluminium (Al), silver (Ag), and an alloy thereof, or may have a double-layer or multi-layer structure formed of molybdenum (Mo), titanium (Ti), copper (Cu), aluminium (Al), or silver (Ag), which are low resistance material, to reduce line resistance. Each of the second to fourth conductive layers may include the same material as that of the first conductive layer, or may include one or more suitable materials of the materials exemplified as the constituent material of the first conductive layer, but the present disclosure is not limited thereto.

The pixel circuit PXC may include at least one transistor T configured to control driving current of the light emitting elements LD. For example, the transistor T may be the first transistor T1 described with reference to FIG. 4.

The transistor T may include a semiconductor pattern and a gate electrode GE that overlaps a portion of the semiconductor pattern. Here, the semiconductor pattern may include an active pattern ACT, a first contact area SE, and a second contact area DE. The first contact area SE may be one of a source area and a drain area, and the second contact area DE may be the other one of the source area and the drain area.

The gate electrode GE may be a second conductive layer located between the gate insulating layer GI and the interlayer insulating layer ILD.

The active pattern ACT, the first contact area SE, and the second contact area DE may be located between the buffer layer BFL and the gate insulating layer GI, and each may be a semiconductor pattern formed of poly silicon, amorphous silicon, an oxide semiconductor, etc. The active pattern ACT, the first contact area SE, and the second contact area DE each may be formed of an undoped semiconductor layer or a semiconductor layer doped with a dopant. For example, each of the first contact area SE and the second contact area DE may be formed of a semiconductor layer doped with a dopant. The active pattern ACT may be formed of an undoped semiconductor layer. For example, an n-type dopant may be used as the dopant, but the present disclosure is not limited thereto.

The active pattern ACT may be an area that overlaps the gate electrode GE of the transistor T, and may be a channel area.

The first contact area SE may be connected to (or brought into contact with) one end of the active pattern ACT of the transistor T. Furthermore, the first contact area SE may be connected to the bridge pattern BRP by the first connector TE1.

The first connector TE1 may be a third conductive layer located between the interlayer insulating layer ILD and the passivation layer PSV. One end of the first connector TE1 may be electrically and/or physically connected to the first contact area SE through a contact hole successively passing through the interlayer insulating layer ILD and the gate insulating layer GI. Furthermore, a remaining end of the first connector TE1 may be electrically and/or physically connected to the bridge pattern BRP through a contact hole passing through the passivation layer PSV located on the interlayer insulating layer ILD.

The bridge pattern BRP may correspond to the fourth conductive layer located between the passivation layer PSV and the via layer VIA. One end of the bridge pattern BRP may be connected to the first contact area SE by the first connector TE1. Furthermore, a remaining end of the bridge pattern BRP may be electrically and/or physically connected with the bottom conductive pattern BML through a contact hole that successively passes through the passivation layer PSV, the interlayer insulating layer ILD, the gate insulating layer GI, and the buffer layer BFL. The bottom conductive pattern BML and the first contact area SE may be electrically connected to each other by the bridge pattern BRP and the first connector TE1.

The bottom conductive pattern BML may correspond to the first conductive layer. For example, the bottom conductive pattern BML may be a conductive layer located between the substrate SUB and the buffer layer BFL. The bottom conductive pattern BML may be electrically connected to the transistor T, and thus may increase a driving range of a certain voltage to be supplied to the gate electrode GE. For example, the bottom conductive pattern BML may be electrically connected to the first contact area SE, and may stabilize the channel area of the transistor T. Furthermore, because the bottom conductive pattern BML is electrically connected to the first contact area SE, a likelihood of the bottom conductive pattern BML floating may be reduced or prevented.

The second contact area DE may be connected to (or brought into contact with) a remaining end of the active pattern ACT of the transistor T. Furthermore, the second contact area DE may be connected to (or brought into contact with) the second connector TE2.

The second connector TE2 may correspond to the third conductive layer. One end of the second connector TE2 may be electrically and/or physically connected to the second contact area DE of the transistor T through a contact hole passing through the interlayer insulating layer ILD and the gate insulating layer GI. A remaining end of the second connector TE2 may be electrically and/or physically connected with the first alignment electrode ALE1 of the display element layer DPL through the first contactor CNT1 that successively passes through the via layer VIA and the passivation layer PSV. In one or more embodiments, the second connector TE2 may be configured to connect the transistor T of the pixel circuit layer PCL with the first alignment electrode ALE1 of the display element layer DPL.

Although there has been illustrated the case where the transistor T is a thin-film transistor having a top gate structure in the foregoing embodiments, the present disclosure is not limited thereto. The structure of the transistor T may be changed in various ways.

The passivation layer PSV may be provided and/or formed on/above the transistor T and the first and second connectors TE1 and TE2.

The pixel circuit layer PCL may include a power line provided and/or formed on the passivation layer PSV. For example, the power line may include the second power line PL2. The second power line PL2 may correspond to the fourth conductive layer located between the passivation layer PSV and the via layer VIA. A voltage of the second driving power supply VSS may be applied to the second power line PL2. Although not directly illustrated in FIGS. 6 to 12, the pixel circuit layer PCL may further include the first power line PL1 described with reference to FIG. 4. The first power line PL1 may be provided on the same layer as that of the second power line PL2, or may be provided on a layer different from that of the second power line PL2. Although in the foregoing embodiments the second power line PL2 has been described as being provided and/or formed on the passivation layer PSV, the present disclosure is not limited thereto. In one or more embodiments, the second power line PL2 may be provided on an insulating layer on which any one conductive layer of the first to fourth conductive layers provided on the pixel circuit layer PCL is located. The location of the second power line PL2 in the pixel circuit layer PCL may be changed in various ways.

The via layer VIA may be provided and/or formed on the bridge pattern BRP and the second power line PL2. The display element layer DPL may be located on the via layer VIA.

The display element layer DPL may include a bank pattern(s) BNP, an alignment electrode(s) ALE, a first bank BNK1, a light emitting element(s) LD, and a pixel electrode(s) PE. Furthermore, the display element layer DPL may include at least one or more insulating layers located between the foregoing components.

The bank pattern BNP may be located on the via layer VIA. For example, the bank pattern BNP may protrude in the third direction DR3 on one surface of the via layer VIA. Hence, one area of each of the alignment electrodes ALE located on the bank pattern BNP may protrude in the third direction DR3 (or in the thickness direction of the substrate SUB).

The bank pattern BNP may include an inorganic insulating layer including inorganic material, or an organic insulating layer including organic material. In one or more embodiments, the bank pattern BNP may include an organic insulating layer having a single layer structure and/or an inorganic insulating layer having a single layer structure, but the present disclosure is not limited thereto. In one or more embodiments, the bank pattern BNP may be provided in a multi-layer structure formed by stacking at least one or more organic insulating layers and at least one or more inorganic insulating layers. However, the material of the bank pattern BNP is not limited to the one or more foregoing embodiments. In one or more embodiments, the bank pattern BNP may include conductive material (or conductive substance).

The bank pattern BNP may include a first bank pattern BNP1 and a second bank pattern BNP2. The first bank pattern BNP1 may be located under the first alignment electrode ALE1 in at least the emission area EMA, and may overlap the first alignment electrode ALE1. The second bank pattern BNP2 may be located under the second alignment electrode ALE2 in at least the emission area EMA, and may overlap the second alignment electrode ALE2.

The bank pattern BNP may generally have a trapezoidal cross-section that is reduced in width from a surface (for example, an upper surface) of the via layer VIA upward in the third direction DR3, but the present disclosure is not limited thereto. In one or more embodiments, the bank pattern BNP may include a cross-sectional shape such as a semi-elliptical shape or a semi-circular shape (or a hemispherical shape) that is reduced in width from one surface of the via layer VIA upward in the third direction DR3. In a sectional view, the shape of the bank pattern BNP is not limited to the foregoing examples, and may be changed in various ways within a range in which the efficiency of light emitted from each of the light emitting elements LD can be enhanced. Furthermore, in some embodiments, at least one of the bank patterns BNP may be omitted, or the position thereof may be changed.

The bank pattern BNP may be used as a reflector. For example, the bank pattern BNP, along with the alignment electrode ALE located thereover, may be used as a reflector to guide light emitted from each light emitting element LD in the image display direction of the display device, so that the light output efficiency of the pixel PXL can be enhanced.

The alignment electrodes ALE1 and ALE2 may be located on the bank pattern BNP.

The alignment electrodes ALE1 and ALE2 may be located on the same plane, and may have the same thickness with respect to the third direction DR3. The alignment electrodes ALE may be concurrently or substantially simultaneously formed through the same process.

The alignment electrodes ALE may be formed of material having a reflectivity to allow light emitted from the light emitting elements LD to travel in the image display direction (or a frontal direction) of the display device. For example, the alignment electrodes ALE may be formed of a conductive material (or substance). The conductive material may include an opaque metal suitable for reflecting light, which is emitted from the light emitting elements LD, in the image display direction of the display device. For example, the opaque metal may include metal such as silver (Ag), magnesium (Mg), aluminium (Al), platinum (Pt), palladium (Pd), gold (Au), nickel (Ni), neodymium (Nd), iridium (Ir), chromium (Cr), titanium (Ti), and an alloy thereof. However, the material of the alignment electrodes ALE is not limited to the one or more foregoing embodiments. In one or more embodiments, the alignment electrodes ALE may include a transparent conductive material (or substance). The transparent conductive material (or substance) may include transparent conductive oxides, such as indium tin oxide (ITO), indium zinc oxide (IZO), zinc oxide (ZnOₓ), indium gallium zinc oxide (IGZO), and indium tin zinc oxide (ITZO), and a conductive polymer such as PEDOT (poly(3,4-ethylenedioxythiophene)). In the case that the alignment electrodes ALE include transparent conductive material (or substance), a separate conductive layer formed of opaque metal for reflecting light emitted from the light emitting elements LD in the image display direction of the display device may be added. However, the material of the alignment electrodes ALE is not limited to the foregoing materials.

Each of the alignment electrodes ALE may be provided and/or formed to have a single-layer structure, but the present disclosure is not limited thereto. In one or more embodiments, each of the alignment electrodes ALE may be provided and/or formed in a multilayer structure formed by stacking at least two materials among metals, alloys, conductive oxides, and conductive polymers. Each of the alignment electrodes ALE may be formed of multiple layers including at least two layers to reduce or minimize distortion resulting from a signal delay in the case that signals (or voltages) are transmitted to the opposite ends EP1 and EP2 of the respective light emitting elements LD. For example, each of the alignment electrodes ALE may have a multi-layer structure that selectively further includes at least one among at least one reflective electrode layer, at least one transparent electrode layer located over and/or under the reflective electrode layer, and/or at least one conductive capping layer configured to cover an upper portion of the transparent electrode layer.

As described above, in the case that the alignment electrodes ALE are formed of conductive material having a reflectivity, light emitted from the opposite ends of each of the light emitting elements LD, for example, the first and second ends EP1 and EP2, may more reliably travel in the image display direction of the display device.

The first alignment electrode ALE1 may be electrically connected with the first transistor T1 of the pixel circuit layer PCL through the first contactor CNT1. The second alignment electrode ALE2 may be electrically connected with the second power line PL2 of the pixel circuit layer PCL through the second contactor CNT2.

The first insulating layer INS1 may be provided and/or formed on the alignment electrodes ALE.

The first insulating layer INS1 may be located on the alignment electrodes ALE and the via layer VIA. The first insulating layer INS1 may be partially open in at least the non-emission area NEMA so that components located thereunder can be exposed. For example, as illustrated in FIG. 12, the first insulating layer INS1 may be partially open to include a first contact hole CH1 that is formed by removing one area of the first insulating layer INS1 in at least the non-emission area NEMA, and may expose a portion of the first alignment electrode ALE1, and also to include a second contact hole CH2 that is formed by removing another area of the first insulating layer INS1 in at least the non-emission area NEMA, and may expose a portion of the second alignment electrode ALE2. Here, the at least non-emission area NEMA may be the second opening OP2 of the first bank BNK1, but the present disclosure is not limited thereto.

The first insulating layer INS1 may be formed of an inorganic insulating layer made of inorganic material. For example, the first insulating layer INS1 may be formed of an inorganic insulating layer suitable for protecting the light emitting elements LD from the pixel circuit layer PCL. For instance, the first insulating layer INS1 may include at least one of silicon nitride (SiNₓ), silicon oxide (SiOₓ), silicon oxynitride (SiOₓN_{y}), and metal oxide such as aluminium oxide (AlOₓ). The first insulating layer INS1 formed of an inorganic insulating layer may have a profile (or a surface) corresponding to profiles of components located thereunder. In this case, a gap (or space) may be present between each of the light emitting elements LD and the first insulating layer INS1.

In one or more embodiments, the first insulating layer INS1 may be formed of an organic insulating layer made of organic material. For example, the first insulating layer INS1 may be formed of an organic insulating layer suitable for mitigating a step difference caused by components, for example, the alignment electrodes ALE and the bank patterns BNP, located under the first insulating layer INS1 in at least the emission area EMA. In this case, as illustrated in FIG. 8, there may be no gap (or space) between each light emitting element LD and the first insulating layer INS1.

The first insulating layer INS1 may be provided to have a single-layer or multi-layer structure. In the case that the first insulating layer INS1 has a multi-layer structure, the first insulating layer INS1 may have a distributed Bragg reflector (DBR) structure formed by alternately stacking first layers and second layers that are formed of inorganic layers, and that have different refractive indexes.

The first insulating layer INS1 may be located over the entirety of the emission area EMA and the non-emission area NEMA of each pixel PXL, but the present disclosure is not limited thereto. In one or more embodiments, the first insulating layer INS1 may be located in only a corresponding area of each pixel PXL, for example, in only the emission area EMA.

The first bank BNK1 may be located on the first insulating layer INS1.

The first bank BNK1 may be located on the first insulating layer INS1 in at least the non-emission area NEMA, but the present disclosure is not limited thereto. The first bank BNK1 may enclose the emission area EMA of each pixel PXL, between adjacent pixels PXL so that a pixel defining layer for partitioning (or defining) the emission area EMA of the corresponding pixel PXL may be formed. At the operation of supplying the light emitting elements LD to the emission area EMA, the first bank BNK1 may be a dam structure configured to prevent a solution (or ink) mixed with the light emitting elements LD from being drawn into the emission areas EMA of the adjacent pixels PXL or control the amount of solution such that a constant amount of solution is supplied to each emission area EMA.

The first bank BNK1 and the bank pattern BNP may be formed through different processes, and may be provided on different layers, but the present disclosure is not limited thereto. In one or more embodiments, the first bank BNK1 and the bank pattern BNP may be formed through different processes and provided on the same layer, or may be formed through the same process and provided on the same layer.

The light emitting elements LD may be supplied to and aligned in the emission area EMA of the pixel PXL in which the first insulating layer INS1 and the first bank BNK1 are formed. For example, the light emitting elements LD may be supplied (or input) to the emission area EMA through an inkjet printing scheme or the like. The light emitting elements LD may be aligned between the alignment electrodes ALE by an electric field formed by a signal (e.g., a predetermined signal or alignment signal) applied to each of the alignment electrodes ALE. For example, the light emitting elements LD may be aligned on the first insulating layer INS1 between the first bank pattern BNP1 on the first alignment electrode ALE1 and the second bank pattern BNP2 on the second alignment electrode ALE2.

The pixel electrodes PE may be located on the light emitting elements LD, the alignment electrode ALE, and the first insulating layer INS1 in at least the emission area EMA. The pixel electrodes PE may include a first pixel electrode PE1 and a second pixel electrode PE2.

In at least the emission area EMA, the first pixel electrode PE1 may be directly located both on the respective first ends EP1 of the light emitting elements LD and on the first insulating layer INS1 over the first alignment electrode ALE1. The first pixel electrode PE1 may be brought into direct contact with, and connected to, the first alignment electrode ALE1 through the first contact hole CH1 of the first insulating layer INS1.

In at least the emission area EMA, the second pixel electrode PE2 may be directly located both on the respective second ends EP2 of the light emitting elements LD and on the first insulating layer INS1 over the second alignment electrode ALE2. The second pixel electrode PE2 may be brought into direct contact with, and connected to, the second alignment electrode ALE2 through the second contact hole CH2 of the first insulating layer INS1.

The first pixel electrode PE1 and the second pixel electrode PE2 may be located on one surface of each of the light emitting elements LD, and spaced apart from each other. For example, the first pixel electrode PE1 located on the first end EP1 of each light emitting element LD, and the second pixel electrode PE2 located on the second end EP2 of the corresponding light emitting element LD, may be located on one surface of the light emitting element LD and spaced apart from each other by a corresponding distance P.

In one or more embodiments, the first pixel electrode PE1 and the second pixel electrode PE2 may be formed through different processes. For example, after the first pixel electrode PE1 is formed through a photolithography process using a mask, the second pixel electrode PE2 is formed through a photolithography process using another mask.

The first pixel electrode PE1 and the second pixel electrode PE2 may include various transparent conductive materials to reduce or minimize loss of light emitted from the light emitting elements LD. In one or more embodiments, the first pixel electrode PE1 and the second pixel electrode PE2 may respectively include different transparent conductive materials. In other words, one pixel electrode (or one electrode) that contacts (or is connected to) the first end EP1 of each light emitting element LD, and another pixel electrode (or another electrode) that contacts (or is connected to) the second end EP2 of the corresponding light emitting element LD may respectively include different transparent conductive materials.

One of the first pixel electrode PE1 and the second pixel electrode PE2 may include crystalline indium tin oxide, and the other one of the first pixel electrode PE1 and the second pixel electrode PE2 may include indium zinc oxide. For example, the first pixel electrode PE1 may include crystalline indium tin oxide, and the second pixel electrode PE2 may include indium zinc oxide.

The first pixel electrode PE1 may be formed in such a way that a base conductive layer including amorphous (or amorphous state) indium tin oxide is applied onto the overall surfaces of the light emitting element LD and the first insulating layer INS1, a conductive pattern having an individual pattern shape is thereafter formed by performing a photolithography process using a mask (hereinafter, referred to as "first mask process"), and then the conductive pattern is crystallized by performing a heat treatment process. The first pixel electrode PE1 may include crystalline indium tin oxide due to the foregoing heat treatment process. The foregoing heat treatment process may include a bake process. The first pixel electrode PE1 that includes crystalline indium tin oxide (or is formed of crystalline indium tin oxide) may have a very low bond density compared to that of amorphous indium tin oxide, so that the first pixel electrode PE1 can have excellent electronic conducting property, and thus may have high electron mobility.

In one or more embodiments, the first pixel electrode PE1 may be designed to have a thickness d1 of a corresponding level or less, for example, about 900 Å or less. The base conductive layer including amorphous indium tin oxide may be partially crystallized during a process of performing the above-mentioned first mask process. In the case that the base conductive layer has a thickness of the certain level or more, the base conductive layer may become resistant to an etchant due to crystallization of the base conductive layer in an etching operation (for example, a wet etching operation) of the first mask process. In this case, the base conductive layer may remain rather than being removed in an area in which the base conductive layer must be completely removed. Thus, a short circuit defect may occur between the first pixel electrode PE1 and the second pixel electrode PE2 because of the residue of the base conductive layer. To prevent the foregoing short circuit defect, in one or more embodiments, the first pixel electrode PE1 may be designed to have a thickness d1 of about 900 Å or less.

The first pixel electrode PE1 including crystalline indium tin oxide may be eventually formed through the heat treatment process that is performed after the foregoing first mask process. Due to the heat treatment process, the first pixel electrode PE1 including crystalline indium tin oxide may not be affected by the etchant that is used during the process of forming the second pixel electrode PE2.

The second pixel electrode PE2 that includes transparent conductive material, for example, indium zinc oxide, different from that of the first pixel electrode PE1 may be designed to have a thickness d2 that is different from the thickness d1 of the first pixel electrode PE1. For example, the thickness d2 of the second pixel electrode PE2 may be designed to be greater than the thickness d1 of the first pixel electrode PE1. The second pixel electrode PE2 including indium zinc oxide may not be crystallized during a fabricating process due to material characteristics, so that the thickness d2 of the second pixel electrode PE2 can be designed to be greater than that of the first pixel electrode PE1.

In one or more embodiments, the first pixel electrode PE1 and the second pixel electrode PE2 may be used as fixing components for fixing the light emitting elements LD. For example, the first pixel electrode PE1 may be directly located on the respective first ends EP1 of the light emitting elements LD, and may fix the first ends EP1 of the corresponding light emitting elements LD. The second pixel electrode PE2 may be directly located on the respective second ends EP2 of the corresponding light emitting elements LD, and may fix the second ends EP2 of the corresponding light emitting elements LD. Because the second pixel electrode PE2 having the thickness d2 that is greater than that of the first pixel electrode PE1 fixes the second end EP2 of each light emitting element LD, the corresponding light emitting element LD can be stably located at the aligned position without being removed from the aligned position. Hence, the number of light emitting elements LD that are lost (or damaged) during the process of fabricating the pixel PXL (or the display device) can be reduced, so that the valid light sources of each pixel PXL can be more reliably secured, whereby the light output efficiency of the pixel PXL may be enhanced.

In one or more embodiments, a separate insulating pattern may be provided to more reliably electrically separate the first pixel electrode PE1 and the second pixel electrode PE2 from each other. For example, as illustrated in FIG. 9, an auxiliary insulating layer AU_INS may be located between the first pixel electrode PE1 and the second pixel electrode PE2. The auxiliary insulating layer AU_INS may be located on the first pixel electrode PE1, and may cover the first pixel electrode PE1 (or may prevent the first pixel electrode PE1 from being exposed to the outside), thus protecting the first pixel electrode PE1. The auxiliary insulating layer AU_INS may include an inorganic insulating layer formed of inorganic material, or an organic insulating layer formed of organic material. For example, the auxiliary insulating layer AU_INS may include at least one of silicon nitride (SiNₓ), silicon oxide (SiOₓ), silicon oxynitride (SiOₓN_{y}), and metal oxide such as aluminium oxide (AlOₓ), but the present disclosure is not limited thereto. Furthermore, the auxiliary insulating layer AU_INS may have a single-layer structure or a multi-layer structure.

As illustrated in one or more embodiments of FIG. 9, in the case that the auxiliary insulating layer AU_INS is located on the first pixel electrode PE1, the auxiliary insulating layer AU_INS may more reliably fix the light emitting elements LD along with the first pixel electrode PE1. The heat treatment process of the process of forming the first pixel electrode PE1 may be performed before the auxiliary insulating layer AU_INS is formed. For example, the auxiliary insulating layer AU_INS may be formed on the first pixel electrode PE1 after the first pixel electrode PE1 having a crystalline state is formed through the heat treatment process. In one or more embodiments, after the auxiliary insulating layer AU_INS is formed on the first pixel electrode PE1 (or a conductive pattern having an individual pattern shape) before the first pixel electrode PE1 is crystallized, the heat treatment process may be performed to crystallize the first pixel electrode PE1.

In one or more embodiments, a protective layer may be selectively located on the first pixel electrode PE1 and the second pixel electrode PE2. The protective layer may be formed of an inorganic insulating layer including inorganic material, or an organic insulating layer including organic material.

Although, in embodiments of FIGS. 6 to 9 and 11, the first pixel electrode PE1 includes crystalline indium tin oxide, and the second pixel electrode PE2 includes indium zinc oxide, the present disclosure is not limited thereto. In one or more embodiments, the opposite case is also possible. For example, as illustrated in FIG. 10, the second pixel electrode PE2 may include crystalline indium tin oxide, and the first pixel electrode PE1 may include indium zinc oxide. In this case, the thickness of the first pixel electrode PE1 may be designed to be greater than that of the second pixel electrode PE2. In the one or more embodiments corresponding to FIG. 10, the second pixel electrode PE2 having a crystalline state may be formed by performing a heat treatment process after a photolithography process using a mask is performed, and thereafter, the first pixel electrode PE1 including indium zinc oxide may be formed through another photolithography process using a mask.

In one or more embodiments, the second pixel electrode PE2 including indium zinc oxide is first formed through a photolithography process using a mask, and subsequently, the first pixel electrode PE1 including crystalline indium tin oxide may be formed by performing a heat treatment process after another photolithography process using a mask is formed.

In accordance with the foregoing embodiments, the first pixel electrode PE1 including crystalline indium tin oxide may fix the first end EP1 of each light emitting element LD, and the second pixel electrode PE2 that includes indium zinc oxide and has the thickness d2 that is greater than that of the first pixel electrode PE1 may fix the second end EP2 of the corresponding light emitting element LD. Consequently, a removal of the light emitting elements LD from the set positions may be prevented or mitigated. Therefore, the valid light sources of the pixel PXL can be more reliably secured, and the light output efficiency of the corresponding pixel PXL may be improved.

In accordance with the foregoing embodiments, a process of forming a separate insulating pattern for fixing each light emitting element LD may be omitted, and the efficiency of the fabricating process may be enhanced. Hence, the process of fabricating the display device can be simplified, so that the production cost may be reduced.

In accordance with the foregoing embodiments, because the first pixel electrode PE1 is crystallized through a heat treatment process that is performed after a photolithography process, damage to the first pixel electrode PE1 during the process of forming the second pixel electrode PE2 may be prevented or mitigated. Consequently, the reliability of the first pixel electrode PE1 may be improved.

Although in the foregoing embodiments there has been described that the bank pattern BNP, the alignment electrode ALE, the first insulating layer INS1, the light emitting element LD, and the pixel electrode PE are provided in the order listed, based on one surface of the via layer VIA, the present disclosure is not limited thereto. In one or more embodiments, to discharge (or release) outgas generated from an organic layer (or an organic insulating layer) toward the first bank BNK1, as illustrated in FIG. 11, the alignment electrode ALE, the first insulating layer INS1, the bank pattern BNP, the light emitting element LD, and the pixel electrode PE may be provided in the order listed, based on one surface of the via layer VIA.

In the one or more embodiments corresponding to FIG. 11, the first and second alignment electrodes ALE1 and ALE2 may be located on one surface of the via layer VIA and spaced apart from each other. The first insulating layer INS1 may be located on the first and second alignment electrodes ALE1 and ALE2. The first insulating layer INS1 may be located on the first and second alignment electrodes ALE1 and ALE2 and the via layer VIA. The first insulating layer INS1 may be formed of an organic layer including organic material. For example, the first insulating layer INS1 may be formed of an organic layer suitable for mitigating a step difference caused by components, for example, the first and second alignment electrodes ALE1 and ALE2, located thereunder, and for planarizing a support surface of the light emitting elements LD. Because the first insulating layer INS1 is formed of an organic layer, a surface (or an upper surface) of the first insulating layer INS1 may have a substantially planar profile (or a planar surface). The first insulating layer INS1 may be provided on the via layer VIA formed of an organic layer, and may contact the via layer VIA.

The first bank pattern BNP1, the second bank pattern BNP2, and the first bank BNK1 may be located on the first insulating layer INS1. The first bank BNK1 may be located on the first insulating layer INS1 in at least the non-emission area NEMA. The first bank BNK1 may include an organic layer (or an organic insulating layer). The first bank BNK1 may be connected with (e.g., may be brought into contact with, or may abut on) other insulating layers that are located thereunder, and may be formed of organic layers, and thus may function as an outlet for discharging (or releasing) outgas that occurs from the insulating layers. The first bank pattern BNP1 may be provided and/or formed on the first insulating layer INS1 to correspond to the first alignment electrode ALE1 in at least emission area EMA. The second bank pattern BNP2 may be provided and/or formed on the first insulating layer INS1 to correspond to the second alignment electrode ALE2 in at least the emission area EMA.

In the one or more embodiments corresponding to FIG. 11, the via layer VIA, the first insulating layer INS1, and the first and second bank patterns BNP1 and BNP2 that are formed of organic layers may abut on each other, thus forming an organic stack structure. The organic stack structure may be directly connected with the first bank BNK1 formed of an organic layer. Hence, outgas generated from the organic stack structure may be discharged (or released) to the first bank BNK1. In one or more embodiments, the first bank BNK1 may discharge outgas generated from the organic layers included in the pixel PXL so that a likelihood of the components of the pixel PXL (e.g., the display element layer DPL) deteriorating due to the outgas that remains in the organic layer can be reduced or prevented.

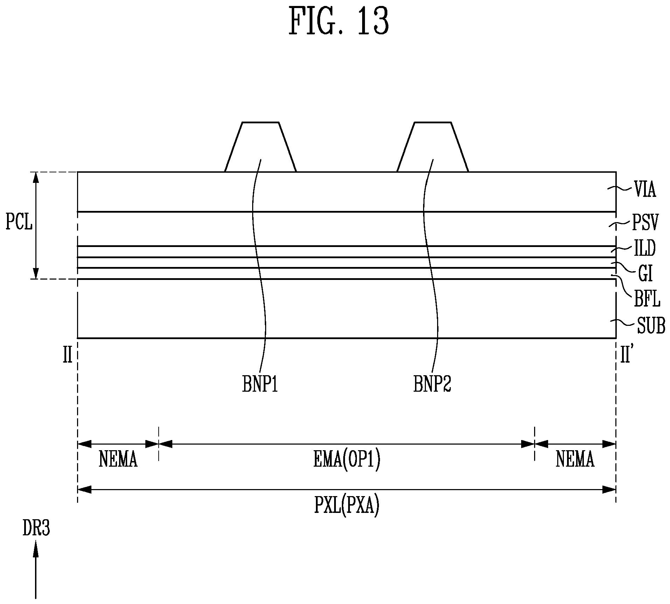

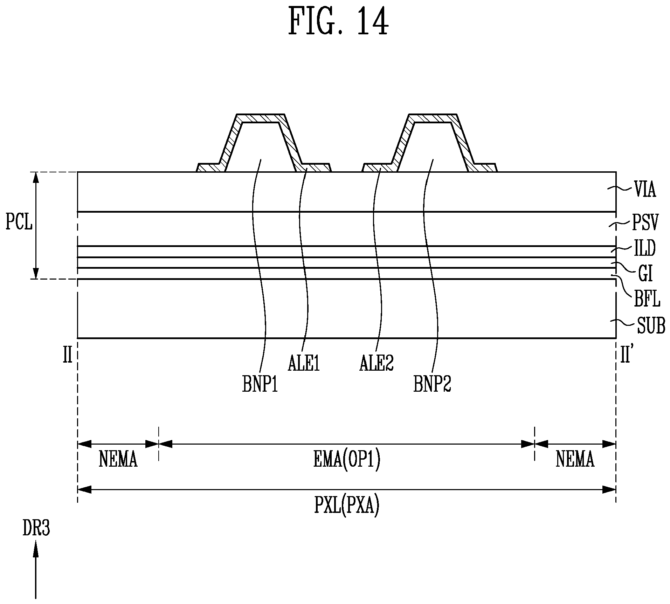

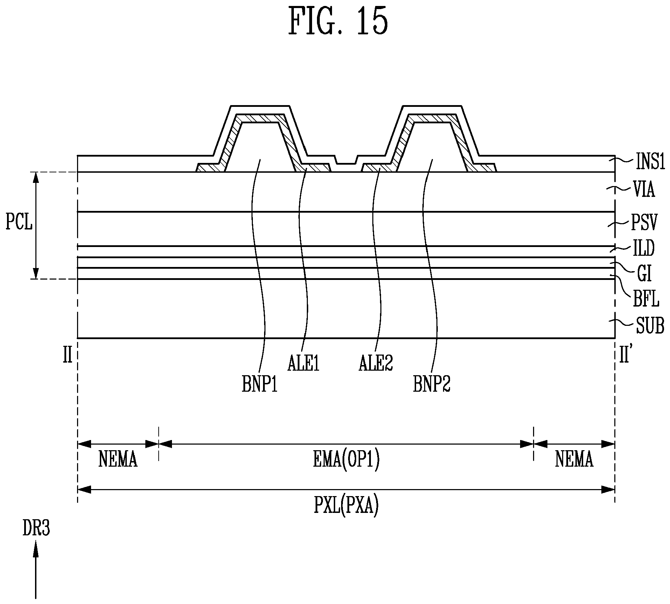

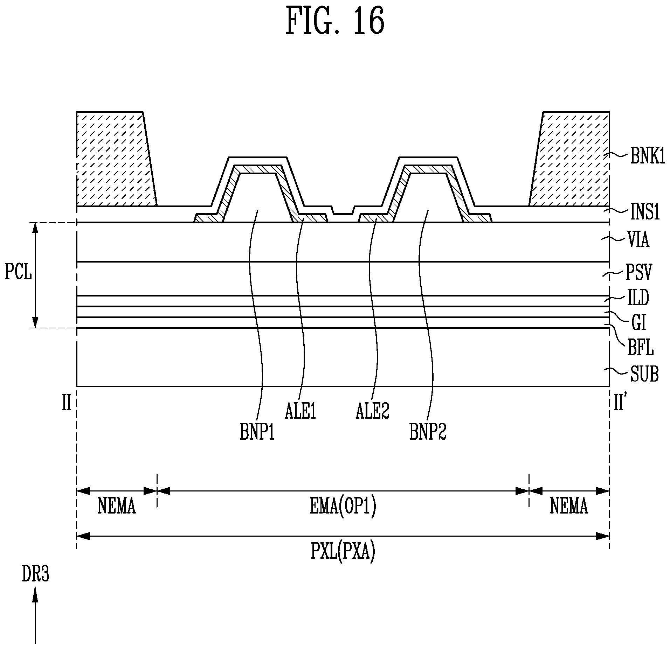

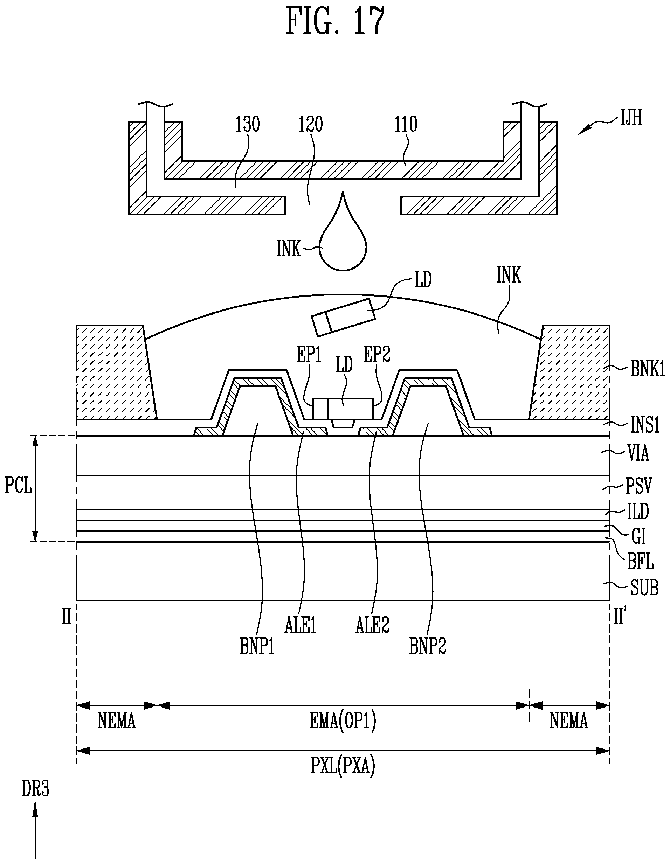

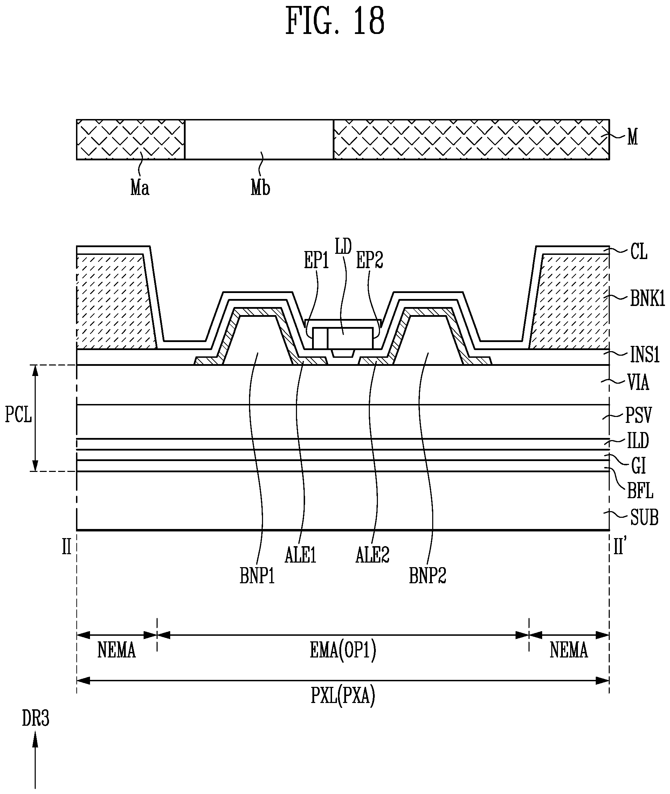

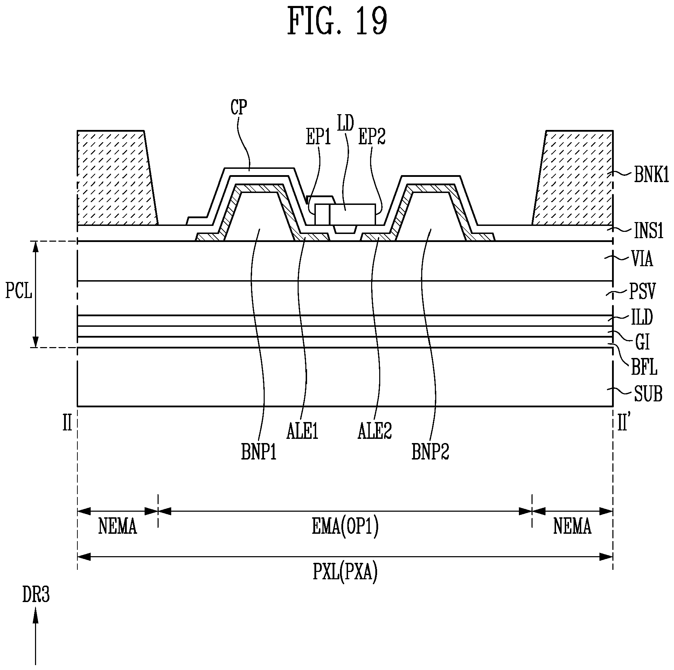

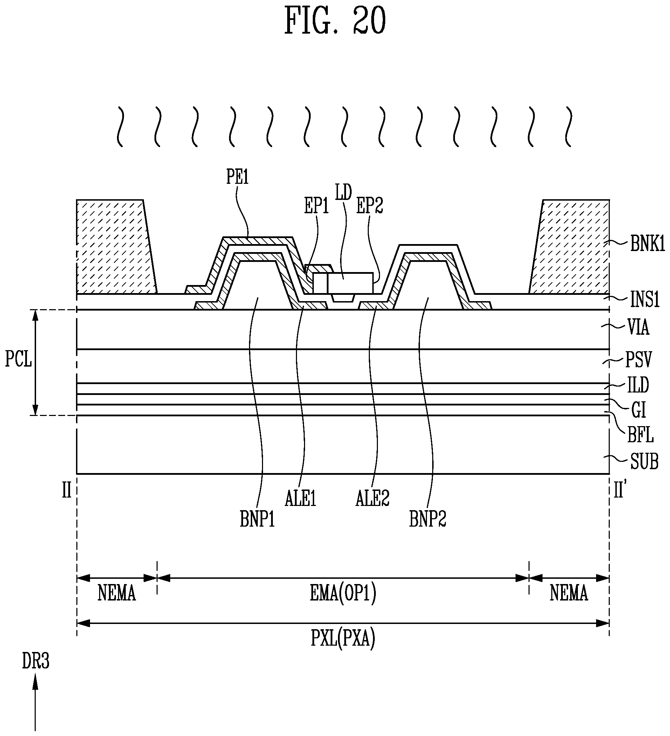

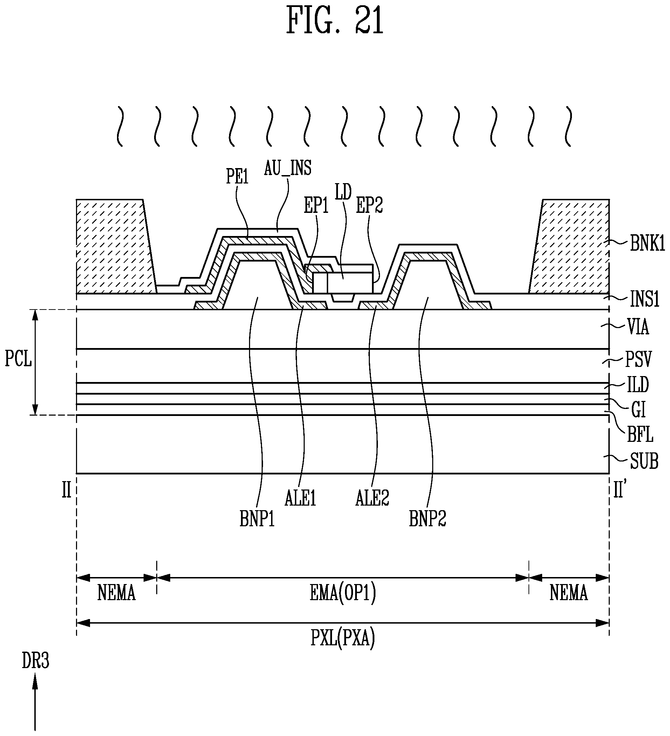

FIGS. 13 to 20 are schematic sectional views for describing a method of fabricating the pixel PXL illustrated in FIG. 7. FIG. 21 is a schematic sectional view illustrating one or more embodiments of the method of fabricating the pixel PXL illustrated in FIG. 19.

Hereinafter, the method of fabricating the pixel PXL in accordance with one or more embodiments shown in FIG. 7 will be sequentially described with reference to FIGS. 13 to 21.

In one or more embodiments, there is illustrated the case where the operations of fabricating the pixel PXL are sequentially performed according to the sectional views, but without changing the scope of the present disclosure, some operations illustrated as being successively performed may be concurrently or substantially simultaneously performed, the sequence of the operations may be changed, some operations may be skipped, or one or more other operations may be further included between the operations.

The description with reference to FIGS. 13 to 21 will be focused on differences from the above-mentioned embodiments so as to avoid redundant description.

Referring to FIGS. 5, 7, and 13, the pixel circuit layer PCL is formed on the substrate SUB. The pixel circuit layer PCL may include the buffer layer BFL, the gate insulating layer GI, the interlayer insulating layer ILD, the passivation layer PSV, and the via layer VIA.

The first bank pattern BNP1 and the second bank pattern BNP2 are formed on the via layer VIA.

Referring to FIGS. 5, 7, 13, and 14, the first alignment electrode ALE1 and the second alignment electrode ALE2 are formed on the first bank pattern BNP1, the second bank pattern BNP2, and the via layer VIA. The first alignment electrode ALE1 may be formed on the first bank pattern BNP1. The second alignment electrode ALE2 may be formed on the second bank pattern BNP2.

The first alignment electrode ALE1 and the second alignment electrode ALE2 may be spaced apart from each other.

Referring to FIGS. 5, 7, and 13 to 15, after an insulating material layer is applied to overall surfaces of the first and second alignment electrodes ALE1 and ALE2, the first and second bank patterns BNP1 and BNP2, and the via layer VIA, and thereafter a photolithography process using a mask is performed, so that the first insulating layer INS1 that is partially open to expose some components located thereunder may be formed. For example, the first insulating layer INS1 may be partially open in the non-emission area NEMA to include the first contact hole CH1 that exposes a portion of the first alignment electrode ALE1, and the second contact hole CH2 that exposes a portion of the second alignment electrode ALE2.

Referring to FIGS. 5, 7, and 13 to 16, the first bank BNK1 is formed by performing a photolithography process using a mask on the first insulating layer INS1 located in the non-emission area NEMA. The first bank BNK1 may be formed of an organic layer including organic material. Because the first bank BNK1 is located in only the non-emission area NEMA, some components corresponding to the first and second openings OP1 and OP2 of the first bank BNK1 may be exposed.

Referring to FIGS. 5, 7, and 13 to 17, an electric field is formed between the first alignment electrode ALE1 and the second alignment electrode ALE2 by respectively applying corresponding alignment signals to the first and second alignment electrodes ALE1 and ALE2.

The light emitting elements LD may be aligned between the first alignment electrode ALE1 and the second alignment electrode ALE2. The light emitting elements LD are supplied (or input) to the pixel area PXA by an inkjet printing scheme or the like. For example, an inkjet head unit IJH may be located such that a nozzle 120 is appropriately located over the first insulating layer INS1 between the first alignment electrode ALE1 and the second alignment electrode ALE2.

The inkjet head unit IJH may include a print head 110, and at least one nozzle 120 located on a lower surface of the print head 110. The print head 110 may have a shape extending in one direction, but the present disclosure is not limited thereto. The print head 110 may include an internal tube 130 formed in the direction in which the print head 110 extends. The nozzle 120 may be coupled to the internal tube 130 of the print head 110. Ink INK including a solvent and a plurality of light emitting elements LD included (or dispersed) in the solvent may be supplied to the internal tube 130. The ink INK may flow along the internal tube 130, and may be sprayed (or discharged) at a preset position from the nozzle 120. The ink INK sprayed from the nozzle 120 may be supplied to the first insulating layer INS1 of the pixel PXL. A spray rate of the ink INK may be adjusted in response to a signal applied to the nozzle 120. The scheme of supplying the light emitting elements LD to the pixel area PXA is not limited to that of the one or more foregoing embodiments. The scheme of supplying the light emitting elements LD may be changed in various ways.

Due to the electric field formed between the first alignment electrode ALE1 and the second alignment electrode ALE2, self-alignment of the light emitting elements LD may be induced on the first insulating layer INS1 between the first alignment electrode ALE1 and the second alignment electrode ALE2.

After the light emitting elements LD are self-aligned, a solvent included in the ink may be removed by a volatilization scheme or other schemes.

Referring to FIGS. 5, 7, and 13 to 18, after the light emitting elements LD are aligned, a base conductive layer CL is formed on an overall surface of the pixel area PXA, and a photolithography process using a mask M is performed. The base conductive layer CL may include amorphous indium tin oxide.

In some embodiments, after a photoresist layer is applied onto the base conductive layer CL, the mask M including a first part Ma and a second part Mb is located on the photoresist layer. The first part Ma may block or transmit irradiated light depending on the type of photoresist layer. The second part Mb may transmit or block irradiated light depending on the type of photoresist layer. The photoresist layer may be a positive type in which a portion onto which light is irradiated is removed during a develop process, or a negative type in which the portion onto which light is irradiated remains during the develop process.

The second part Mb of the mask M may correspond to an area in which the first pixel electrode PE1 is to be formed in at least the emission area EMA. The first part Ma of the mask M may correspond to a remaining area other than the area in which the first pixel electrode PE1 is to be formed.

After the foregoing mask M is located over the photoresist layer on the base conductive layer CL, light is irradiated thereto.

Referring to FIGS. 5, 7, and 13 to 19, a conductive pattern CP is formed by patterning the base conductive layer CL through a develop process and an etching process. The conductive pattern CP may be located both on the first insulating layer INS1 over the first alignment electrode ALE1, and on the first end EP1 of each light emitting element LD. The conductive pattern CP may be one area of the base conductive layer CL that corresponds to the second part Mb of the mask M. The conductive pattern CP may include amorphous indium tin oxide.

Referring to FIGS. 5, 7, and 13 to 20, the first pixel electrode PE1 including crystalline indium tin oxide is formed by crystallizing the conductive pattern CP by performing a heat treatment process after the foregoing etching process is performed.

The heat treatment process may be performed at about 200 °C for about thirty minutes. The heat treatment process may include, for example, a bake process.

The first pixel electrode PE1 may be electrically and/or physically connected with the first alignment electrode ALE1 through the first contact hole CH1 of the first insulating layer INS1 in the non-emission area NEMA.

In one or more embodiments, to more reliably electrically separate/insulate the first pixel electrode PE1 and the second pixel electrode PE2 from each other, as illustrated in FIG. 21, the auxiliary insulating layer AU_INS may be provided on one surface of each light emitting element LD. The auxiliary insulating layer AU_INS may be formed on the conductive pattern CP including amorphous indium tin oxide. After the auxiliary insulating layer AU_INS is formed on the conductive pattern CP, the first pixel electrode PE1 including crystalline indium tin oxide may be formed by crystallizing the conductive pattern CP by performing the heat treatment process.

In one or more embodiments, the auxiliary insulating layer AU_INS may be formed on the first pixel electrode PE1 including crystalline indium tin oxide through the heat treatment process.

After the foregoing heat treatment process is performed, the second pixel electrode PE2 may be formed on the second end EP2 of each light emitting element LD. The second pixel electrode PE2 may include transparent conductive material that is different from that of the first pixel electrode PE1. For example, the second pixel electrode PE2 may include indium zinc oxide. The second pixel electrode PE2 may have a thickness that is greater than that of the first pixel electrode PE1, and thus may more stably fix the second end EP2 of each light emitting element LD.

The second pixel electrode PE2 may be electrically and/or physically connected with the second alignment electrode ALE2 through the second contact hole CH2 of the first insulating layer INS1 in the non-emission area NEMA.

In accordance with the foregoing embodiments, the first pixel electrode PE1 including crystalline indium tin oxide may fix the first end EP1 of each light emitting element LD without using a separate insulating pattern for fixing each light emitting element LD, and the second pixel electrode PE2 that includes indium zinc oxide and has a thickness greater than that of the first pixel electrode PE1 may fix the second end EP2 of the corresponding light emitting element LD, so that the light emitting elements LD can be mitigated or prevented from being removed from set positions.

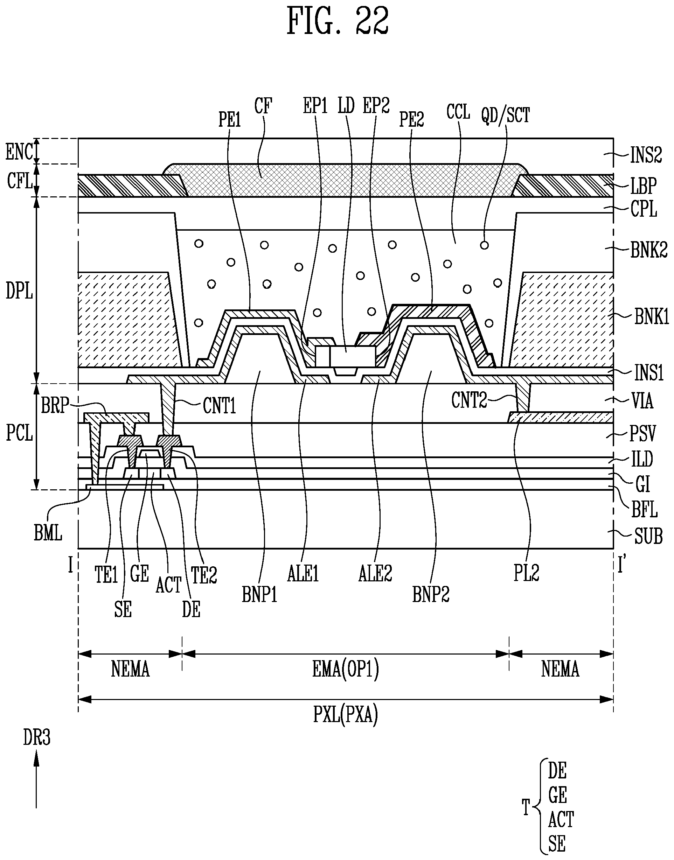

FIGS. 22 to 24 schematically illustrate a pixel PXL in accordance with one or more embodiments, and are schematic sectional views corresponding to line I-I' of FIG. 5.

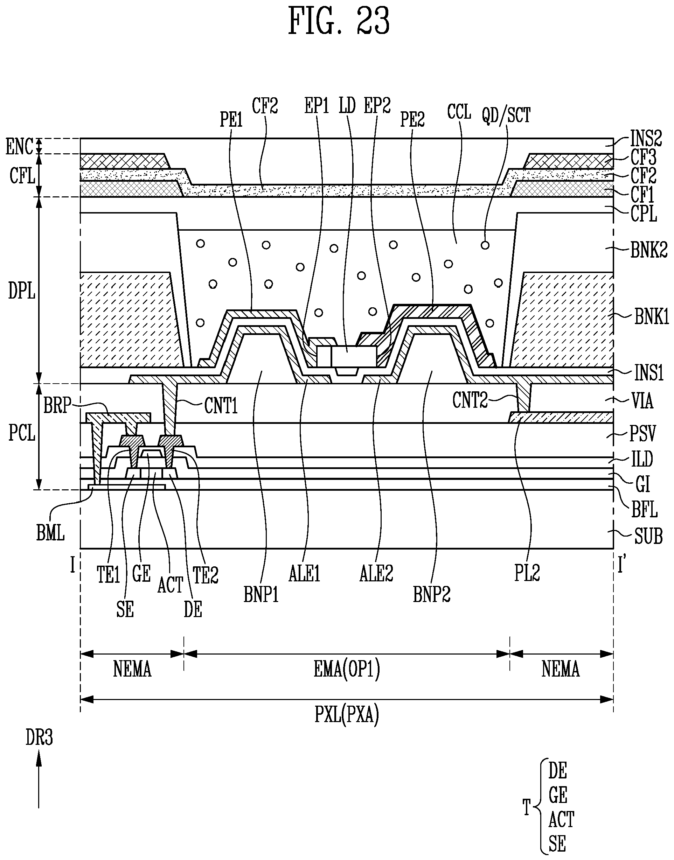

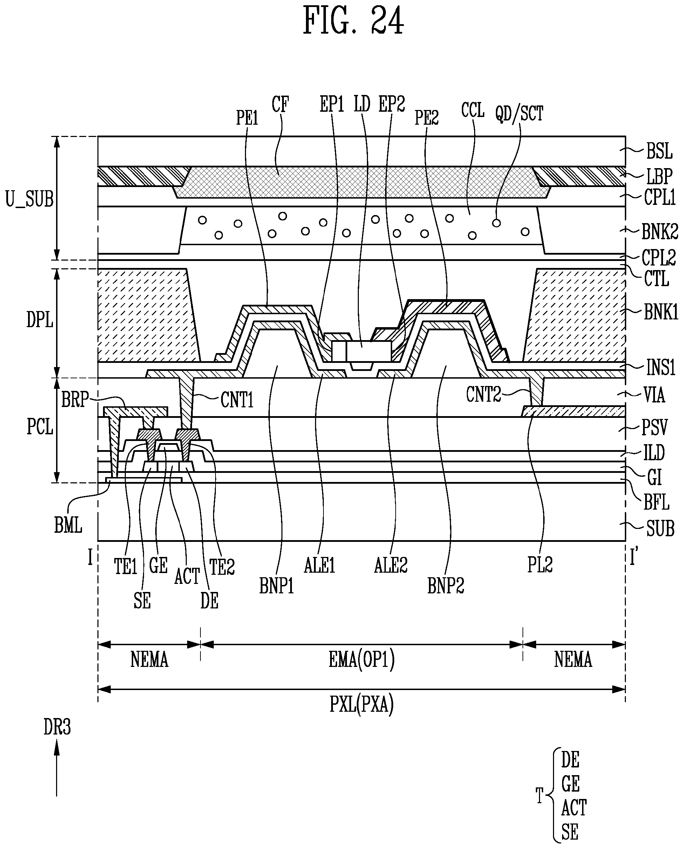

FIGS. 22 to 24 illustrate different embodiments with regard to the position of a color conversion layer CCL. For example, FIGS. 22 and 23 illustrate one or more embodiments in which the color conversion layer CCL is located over the first and second pixel electrodes PE1 and PE2 through a successive process. FIG. 24 illustrates one or more embodiments in which an upper substrate U_SUB including the color conversion layer CCL is located on the first and second pixel electrodes PE1 and PE2 through an adhesion process using an intermediate layer CTL.

The following description related to embodiments of FIGS. 22 to 24 will be focused on differences from the above-mentioned embodiments so as to avoid redundant description.

Referring to FIGS. 1 to 24, the display element layer DPL of each pixel PXL may further include a color conversion layer CCL located in the emission area EMA, and a second bank BNK2 located in the non-emission area NEMA.

The second bank BNK2 may be provided and/or formed on the first bank BNK1 in the non-emission area NEMA of the pixel PXL. The second bank BNK2 may be a structure that encloses the emission area EMA, and defines a position at which the color conversion layer CCL is to be supplied, thus eventually defining the emission area EMA. For example, the second bank BNK2 may be a structure that defines a supply (or input) position of the color conversion layer CCL in each pixel PXL, and eventually defines the emission area EMA of the corresponding pixel PXL.

The second bank BNK2 may include light block material. For example, the second bank BNK2 may be a black matrix. In one or more embodiments, the second bank BNK2 may include at least one light block material and/or reflective material, and may allow light emitted from the color conversion layer CCL to more reliably travel in the image display direction (or the third direction DR3) of the display device, thus enhancing the light output efficiency of color conversion layer CCL.

The color conversion layer CCL may be formed on (or over) the first pixel electrode PE1 and the second pixel electrode PE2 in the emission area EMA that is enclosed by the second bank BNK2.

The color conversion layer CCL may include color conversion particles QD corresponding to a corresponding color. For example, the color conversion layer CCL may include color conversion particles QD that convert a first color of light emitted from the light emitting elements LD to a second color (or a corresponding color) of light.

In the case that the pixel PXL is a red pixel (or a red sub-pixel), the color conversion layer CCL may include color conversion particles QD formed of red quantum dots that convert a first color of light emitted from the light emitting elements LD to a second color of light, for example, red light.

In the case that the pixel PXL is a green pixel (or a green sub-pixel), the color conversion layer CCL may include color conversion particles QD formed of green quantum dots that convert a first color of light emitted from the light emitting elements LD to a second color of light, for example, green light.

In the case that the pixel PXL is a blue pixel (or a blue sub-pixel), the color conversion layer CCL may include color conversion particles QD formed of blue quantum dots that convert a first color of light emitted from the light emitting elements LD to a second color of light, for example, blue light. In one or more embodiments, in the case that the pixel PXL is a blue pixel (or a blue sub-pixel), there may be provided a light scattering layer including light scattering particles SCT, in place of the color conversion layer CCL including the color conversion particles QD. For example, in the case that the light emitting elements LD emit blue-based light, the pixel PXL may include a light scattering layer including light scattering particles SCT. The light scattering layer may be omitted depending on embodiments. In one or more embodiments, in the case that the pixel PXL is a blue pixel (or a blue sub-pixel), there may be provided a transparent polymer, in place of the color conversion layer CCL.

The display element layer DPL may include a capping layer CPL that is located on the color conversion layer CCL and the second bank BNK2.

The capping layer CPL may be provided on the overall surface of, or the entirety of, the pixel area PXA of the pixel PXL to cover the second bank BNK2 and the color conversion layer CCL. The capping layer CPL may be directly located on the second bank BNK2 and the color conversion layer CCL. The capping layer CPL may be formed of an inorganic insulating layer including inorganic material. The capping layer CPL may include at least one of silicon nitride (SiNₓ), silicon oxide (SiOₓ), silicon oxynitride (SiOₓN_{y}), and metal oxide such as aluminium oxide (AlOₓ). The capping layer CPL may cover the entirety of the second bank BNK2 and the color conversion layer CCL, and thus may reduce or prevent external water or moisture from being drawn into the display element layer DPL.

The capping layer CPL may mitigate a step difference formed by components located thereunder, and may have a planar surface. For example, the capping layer CPL may include an organic insulating layer including organic material. The capping layer CPL may be a common layer provided in common in the display area DA, but the present disclosure is not limited thereto.

A color filter layer CFL may be provided and/or formed on the capping layer CPL.

In one or more embodiments of FIG. 22, the color filter layer CFL may include a color filter CF corresponding to the color of each pixel PXL, and a light block pattern LBP adjacent to the color filter CF.

The color filter CF may include a color filter material that allows a corresponding color of light converted by the color conversion layer CCL to selectively pass therethrough. The color filter CF may include a red color filter, a green color filter, and/or a blue color filter. The color filter CF may be provided on one surface of the capping layer CPL, and may correspond to the color conversion layer CCL.

The light block pattern LBP may be located on one surface of the capping layer CPL at a position adjacent to the color filter CF. For example, the light block pattern LBP may be located on one surface of the capping layer CPL, and may correspond to the non-emission area NEMA. The light block pattern LBP may correspond to the second bank BNK2. The light block pattern LBP may include light block material for reducing or preventing light leakage wherein light (or rays) leaks from the pixel PXL to pixels PXL adjacent thereto. For example, the light block pattern LBP may include a black matrix. The light block pattern LBP may reduce or prevent mixture of different colors of light emitted from respective adjacent pixels PXL.

In one or more embodiments of FIG. 23, the color filter layer CFL may include a first color filter CF1, a second color filter CF2, and a third color filter CF3. The second color filter CF2 may be located on the capping layer CPL over the emission area EMA and the non-emission area NEMA of the pixel PXL. The first and third color filters CF1 and CF3 may be located in the non-emission area NEMA of the corresponding pixel PXL.

In the non-emission area NEMA, the first color filter CF1, the second color filter CF2, and the third color filter CF3 may be stacked in the order listed. For example, the first color filter CF1 may be located on one surface of the capping layer CPL in the non-emission area NEMA. The second color filter CF2 may be located on the first color filter CF1 in the non-emission area NEMA. The third color filter CF3 may be located on the second color filter CF2 in the non-emission area NEMA. In the non-emission area NEMA, the first color filter CF1, the second color filter CF2, and the third color filter CF3 may overlap each other.

The first, second, and third color filters CF1, CF2, and CF3 that overlap each other on the capping layer CPL of the non-emission area NEMA allow different colors of light to selectively pass therethrough. For example, the first color filter CF1 may be a red color filter configured to allow red light to selectively pass therethrough. The second color filter CF2 may be a green color filter configured to allow green light to selectively pass therethrough. The third color filter CF3 may be a blue color filter configured to allow blue light to selectively pass therethrough. In the non-emission area NEMA of the pixel area PXA, the first color filter CF1, the second color filter CF2, and the third color filter CF3 that are successively stacked may be used as a light block component for blocking or substantially reducing transmission of light.

An encapsulation layer ENC may be provided and/or formed on the color filter layer CFL.

The encapsulation layer ENC may include a second insulating layer INS2. The second insulating layer INS2 may be an inorganic insulating layer including inorganic material, or an organic insulating layer including organic material. The second insulating layer INS2 may cover the entirety of components located thereunder, and may reduce or prevent external water or moisture from being drawn into the color filter layer CFL and the display element layer DPL.

In the display device (e.g., in each sub-pixel, or in each pixel PXL), in accordance with the foregoing embodiments, the color conversion layer CCL and the color filter CF may be located on the light emitting element LD so that light having excellent color reproducibility can be emitted through the color conversion layer CCL and the color filter CF, whereby the light output efficiency may be enhanced.

In one or more embodiments, the second insulating layer INS2 may be formed of multiple layers. For example, the second insulating layer INS2 may be formed of at least two inorganic insulating layers, and at least one organic insulating layer interposed between the at least two inorganic insulating layers. Here, the constituent material and/or structure of the second insulating layer INS2 may be changed in various ways. In some embodiments, at least one overcoat layer, at least one filler layer, and/or at least one upper substrate, etc., may be further located over the second insulating layer INS2.

Although in the foregoing embodiments the color conversion layer CCL has been described as being directly formed on the first pixel electrode PE1 and the second pixel electrode PE2, the present disclosure is not limited thereto. In one or more embodiments, as illustrated in FIG. 24, the color conversion layer CCL may be formed on a separate substrate, for example, an upper substrate U_SUB, and coupled to the display element layer DPL including the first pixel electrode PE1 and the second pixel electrode PE2 through an intermediate layer CTL or the like.

The intermediate layer CTL may be a transparent adhesive layer (or a transparent bonding layer), for example, an optically clear adhesive layer, for enhancing the adhesive force between the display element layer DPL and the upper substrate U_SUB, but the present disclosure is not limited thereto. In one or more embodiments, the intermediate layer CTL may be a refractive index conversion layer configured to change the refractive index of light emitted from the light emitting elements LD toward the upper substrate U_SUB, and to enhance emission luminance of the pixel PXL. In one or more embodiments, the intermediate layer CTL may include a filler formed of insulating material having an insulation property and an adhesion property.

The upper substrate U_SUB may form a window component and/or an encapsulation substrate of the display device. The upper substrate U_SUB may include a base layer BSL (or a base substrate), the color conversion layer CCL, the second bank BNK2, the color filter CF, the light block pattern LBP, and first and second capping layers CPL1 and CPL2.

The base layer BSL may be a rigid or flexible substrate, and the material or properties thereof are not particularly limited. The base layer BSL may be formed of the same material as that of the substrate SUB, or may be formed of material that is different from that of the substrate SUB.

In FIG. 24, the color conversion layer CCL may be located on one surface of the first capping layer CPL1, and may face the display element layer DPL. The color filter CF may be provided on (e.g., below) one surface of the base layer BSL, and may correspond to the color conversion layer CCL.

The first capping layer CPL1 may be provided and/or formed between the color filter CF and the color conversion layer CCL.

The first capping layer CPL1 may be located on the color filter CF, and may cover the color filter CF, thus protecting the color filter CF. The first capping layer CPL1 may be an inorganic layer including inorganic material, or an organic layer including organic material.

The light block pattern LBP may be located adjacent to the color filter CF. The light block pattern LBP may be located on one surface of the base layer BSL, and may correspond to the non-emission area NEMA of each pixel PXL.

The light block pattern LBP may be located on (e.g., below) one surface of the base layer BSL, and may be located adjacent to the color filter CF. The first capping layer CPL1 may be provided and/or formed on the light block pattern LBP.

The color conversion layer CCL and the second bank BNK2 may be located on (e.g., below) one surface of the first capping layer CPL1. The second bank BNK2 may be a structure that ultimately defines the emission area EMA of each pixel PXL. At the operation of supplying the color conversion layer CCL, the second bank BNK2 may be a dam structure that ultimately defines the emission area EMA to which the color conversion layer CCL is to be supplied.

The second capping layer CPL2 may be provided and/or formed on (below) overall surfaces of the color conversion layer CCL and the second bank BNK2.

The second capping layer CPL2 may include at least one of silicon nitride (SiNₓ), silicon oxide (SiOₓ), silicon oxynitride (SiOₓN_{y}), and metal oxide, such as aluminium oxide (AlOₓ), but the present disclosure is not limited thereto. In one or more embodiments, the second capping layer CPL2 may be formed of an organic layer including organic material. The second capping layer CPL2 may be located on the color conversion layer CCL, and may protect the color conversion layer CCL from external water or moisture so that the reliability of the color conversion layer CCL can be further enhanced.

The upper substrate U_SUB may be connected with the display element layer DPL by the intermediate layer CTL.

FIG. 25 is a circuit diagram illustrating one or more embodiments of an electrical connection relationship of components included in each pixel PXL illustrated in FIG. 3.

Referring to FIGS. 3 and 25, the pixel PXL may include an emission part EMU and a pixel circuit PXC. The pixel circuit PXC is substantially identical with the pixel circuit PXC described with reference to FIG. 4, and repetitive explanation thereof will be omitted.

The emission part EMU may include a plurality of light emitting elements LD connected in parallel between a first power line PL1 that is connected to a first driving power supply VDD, and to which a voltage of the first driving power supply VDD is applied, and a second power line PL2 that is connected to a second driving power supply VSS, and to which a voltage of the second driving power supply VSS is applied.

The emission part EMU may include at least one serial set including a plurality of light emitting elements LD connected in parallel to each other. In other words, as illustrated in FIG. 25, the emission part EMU may have a serial/parallel combination structure.

The emission part EMU may include first and second serial sets (or stages) SET1 and SET2 that are successively connected between the first and second driving power supplies VDD and VSS. Each of the first and second serial sets SET1 and SET2 may include two electrodes, respectively PE1 and CTE1, and CTE2 and PE2, which form an electrode pair of the corresponding serial set, and a plurality of light emitting elements LD connected in parallel to each other in the same direction between the respective pairs of electrodes PE1 and CTE1, and CTE2 and PE2.

The first serial set SET1 may include a first pixel electrode PE1, a first intermediate electrode CTE1, and at least one first light emitting element LD1 connected between the first pixel electrode PE1 and the first intermediate electrode CTE1. Furthermore, the first serial set SET1 may include a reverse light emitting element LDr connected between the first pixel electrode PE1 and the first intermediate electrode CTE1 in a direction that is opposite to that of the first light emitting element LD1.

The second serial set SET2 may include a second intermediate electrode CTE2, a second pixel electrode PE2, and at least one second light emitting element LD2 connected between the second intermediate electrode CTE2 and the second pixel electrode PE2. Furthermore, the second serial set SET2 may include a reverse light emitting element LDr connected between the second intermediate electrode CTE2 and the second pixel electrode PE2 in a direction that is opposite to that of the second light emitting element LD2.

The first intermediate electrode CTE1 of the first serial set SET1 and the second intermediate electrode CTE2 of the second serial set SET2 may be integrally provided and connected to each other. In other words, the first intermediate electrode CTE1 and the second intermediate electrode CTE2 may form an intermediate electrode CTE that electrically connects the first serial set SET1 and the second serial set SET2 that are successively provided. In the case where the first intermediate electrode CTE1 and the second intermediate electrode CTE2 are integrally provided, the first intermediate electrode CTE1 and the second intermediate electrode CTE2 may be respective different areas of the intermediate electrode CTE.

In the foregoing embodiments, the first pixel electrode PE1 of the first serial set SET1 may be an anode of the emission part EMU of the pixel PXL. The second pixel electrode PE2 of the second serial set SET2 may be a cathode of the emission part EMU.

As described above, the emission part EMU of the pixel PXL including the serial sets SET1 and SET2 (or the light emitting elements LD) connected to each other in the serial/parallel combination structure may suitably adjust driving current/voltage conditions in response to specifications of a product to which the emission part EMU is to be applied.

For example, the emission part EMU of the pixel PXL including the serial sets SET1 and SET2 (or the light emitting elements LD) connected to each other in the serial/parallel combination structure may reduce driving current, compared to that of an emission component having a structure such that the light emitting elements LD are connected only in parallel to each other. Furthermore, the emission part EMU of the pixel PXL including the serial sets SET1 and SET2 connected to each other in the serial/parallel combination structure may reduce driving current to be applied to the opposite ends of the emission part EMU, as compared to that of an emission component having a structure such that all of the light emitting elements LD are connected in series to each other (the number of light emitting elements LD being the same as that of the emission part EMU). In addition, the emission part EMU of the pixel PXL including the serial sets SET1 and SET2 (or the light emitting elements LD) connected to each other in the serial/parallel combination structure may increase the number of light emitting elements LD included between the electrodes PE1, CTE1, CTE2, and PE2, as compared to that of an emission component having a structure such that all of the serial sets (or stages) are connected in series to each other. In this case, the light output efficiency of the light emitting elements LD may be enhanced. Even if a defect is caused in a corresponding serial set (or stage), the ratio of light emitting elements LD that cannot emit light due to the defect may be reduced, so that a reduction in the light output efficiency of the light emitting elements LD can be mitigated.

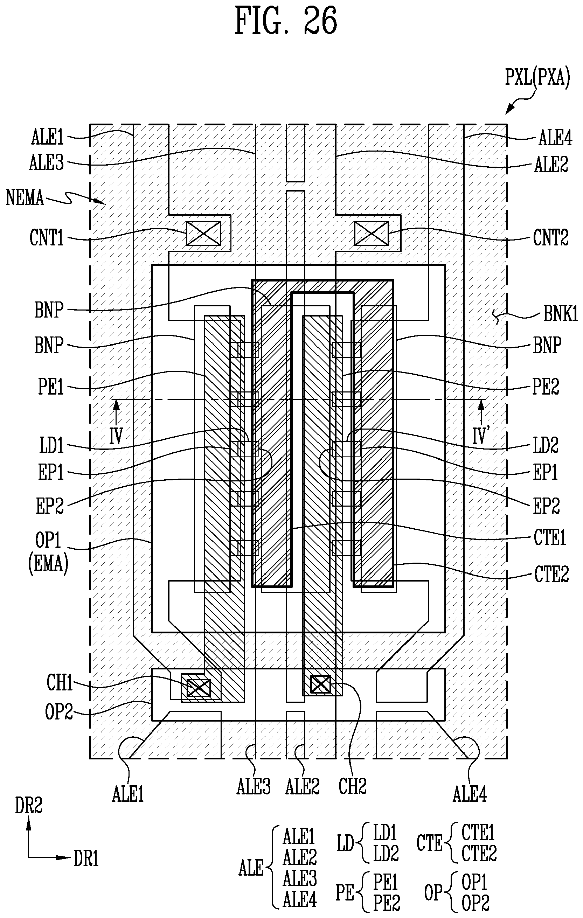

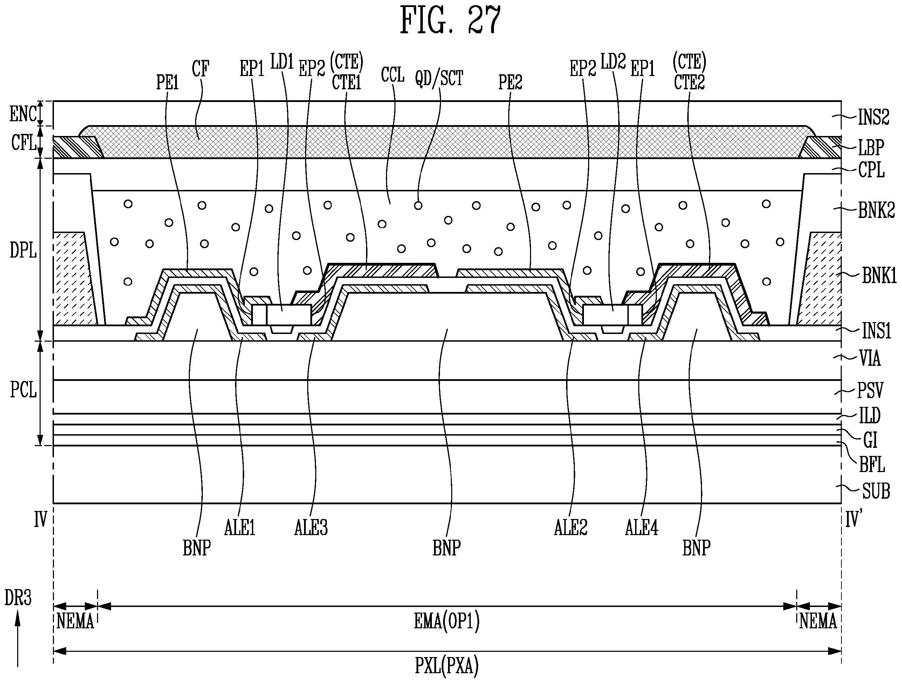

FIG. 26 is a plan view schematically illustrating each pixel PXL illustrated in FIG. 3. FIG. 27 is a schematic sectional view taken along the line IV-IV' of FIG. 26.

In FIG. 26, for the sake of explanation, illustration of transistors electrically connected to the light emitting elements LD and signal lines connected to the transistors is omitted.

For the sake of explanation, in FIG. 26, a horizontal direction in a plan view is indicated by the first direction DR1, and a vertical direction in the plan view is indicated by the second direction DR2. In FIG. 27, a vertical direction (or a thickness direction of the substrate SUB) in a sectional view is indicated by the third direction DR3.

The description with reference to FIGS. 26 and 27 will be focused on differences from the above-mentioned embodiments so as to avoid redundant description.

Referring to FIGS. 3, and 25 to 27, the pixel PXL may be provided and/or formed in a pixel area PXA defined on the substrate SUB. The pixel area PXA may include an emission area EMA and a non-emission area NEMA.

The pixel PXL may include a substrate SUB, a pixel circuit layer PCL, and a display element layer DPL.

The pixel circuit layer PCL may include a buffer layer BFL, at least one transistor provided on the buffer layer BFL, a passivation layer PSV provided on the transistor, and a via layer VIA provided on the passivation layer PSV.

The display element layer DPL may be provided and/or formed on the via layer VIA of the pixel circuit layer PCL.

The display element layer DPL may include bank patterns BNP, alignment electrodes ALE, a first bank BNK1, light emitting elements LD, pixel electrodes PE, and an intermediate electrode CTE. Furthermore, the display element layer DPL may include at least one or more insulating layers located between the foregoing components. Furthermore, the display element layer DPL may include a second bank BNK2 that overlaps the first bank BNK1, and a color conversion layer CCL that is enclosed by the second bank BNK2 and located on the pixel electrodes PE.

A color filter layer CFL and an encapsulation layer ENC may be successively located on the display element layer DPL.

The bank patterns BNP may protrude in the third direction DR3 on one surface of the via layer VIA in at least the emission area EMA. Hence, one area of each of the alignment electrodes ALE located on the bank patterns BNP may protrude in the third direction DR3 (or the thickness direction of the substrate SUB).

The alignment electrodes ALE may be located on the bank patterns BNP.

The alignment electrodes ALE may include a first alignment electrode ALE1, a third alignment electrode ALE3, a second alignment electrode ALE2, and a fourth alignment electrode ALE4 that are spaced apart from each other. The first alignment electrode ALE1 may be located on a corresponding bank pattern BNP (for example, a bank pattern BNP located at the left side in a plan view) among the bank patterns BNP. The second and third alignment electrodes ALE2 and ALE3 may be located on a corresponding bank pattern BNP (for example, a bank pattern BNP located at the center in the plan view) among the bank patterns BNP. The fourth alignment electrode ALE4 may be located on a corresponding bank pattern BNP (for example, a bank pattern BNP located at the right side in a plan view) among the bank patterns BNP.

The first, third, second, and fourth alignment electrodes ALE1, ALE3, ALE2, and ALE4 may be separated from other electrodes (for example, first, third, second, and fourth alignment electrodes ALE1, ALE3, ALE2, and ALE4 provided in each of pixels PXL adjacent thereto in the second direction DR2) in the second opening OP2 of the first bank BNK1 after the light emitting elements LD are supplied to, and aligned in, the pixel area PXA of the corresponding pixel PXL during a process of fabricating the display device.

The first alignment electrode ALE1 may be electrically connected with the first transistor T1 described with reference to FIG. 25 through the first contactor CNT1. The second alignment electrode ALE2 may be electrically connected with the second driving power supply VSS (or the second power line PL2) described with reference to FIG. 25 through the second contactor CNT2.

In the pixel area PXA of the pixel PXL, each of the first, third, second, and fourth electrodes ALE1, ALE3, ALE2, and ALE4 may be located at a position spaced apart from an electrode adjacent thereto in the first direction DR1.

Each of the first, third, second, and fourth alignment electrodes ALE1, ALE3, ALE2, and ALE4 may function as an alignment electrode (or an alignment line) configured to receive, before the light emitting elements LD are aligned in the emission area EMA of the pixel PXL, an alignment signal (or an alignment voltage) from an alignment pad located in the non-display area (refer to "NDA" of FIG. 3), and then may align the light emitting elements LD. The third alignment electrode ALE3 may be integrally formed with the second alignment electrode ALE2, and may be electrically and/or physically connected to the second alignment electrode ALE2.

A first insulating layer INS1 may be formed on the first, third, second, and fourth alignment electrodes ALE1, ALE3, ALE2, and ALE4, the bank patterns BNP, and the via layer VIA.

The first bank BNK1 may be located on the first insulating layer INS1. The first bank BNK1 may be located on the first insulating layer INS1 of the non-emission area NEMA of the pixel PXL, and may form a pixel defining layer that encloses the emission area EMA of the corresponding pixel PXL and that is formed between adjacent pixels PXL to define the emission area EMA of each pixel PXL.

The light emitting elements LD may be supplied and aligned in the emission area EMA of the pixel PXL.

The light emitting elements LD may be located between two adjacent alignment electrodes of the first, third, second, and fourth alignment electrodes ALE1, ALE3, ALE2, and ALE4. The light emitting elements LD may include a first light emitting element LD1 and a second light emitting element LD2.

The first light emitting element LD1 may be aligned on the first insulating layer INS1 between the first alignment electrode ALE1 and the third alignment electrode ALE3. The second light emitting element LD2 may be aligned on the first insulating layer INS1 between the second alignment electrode ALE2 and the fourth alignment electrode ALE4. In one or more embodiments, a plurality of first light emitting elements LD1 and a plurality of second light emitting elements LD2 may be provided. The first end EP1 of each of the first light emitting elements LD1 may be electrically connected to the first pixel electrode PE1. The second end EP2 of each of the first light emitting elements LD1 may be electrically connected to the first intermediate electrode CTE1. The first end EP1 of each of the second light emitting elements LD2 may be electrically connected to the second intermediate electrode CTE2. The second end EP2 of each of the second light emitting elements LD2 may be electrically connected to the second pixel electrode PE2.

In at least the emission area EMA, the first pixel electrode PE1 may be located both on the respective first ends EP1 of the first light emitting elements LD1 and on the first insulating layer INS1 over the first alignment electrode ALE1. The first pixel electrode PE1 may be brought into direct contact with, and connected to, the first alignment electrode ALE1 through the first contact hole CH1 in the non-emission area NEMA.

In at least the emission area EMA, the second pixel electrode PE2 may be located both on the respective second ends EP2 of the second light emitting elements LD2, and on the first insulating layer INS1 over the second alignment electrode ALE2. The second pixel electrode PE2 may be brought into direct contact with, and connected to, the second alignment electrode ALE2 through the second contact hole CH2 in the non-emission area NEMA.

In one or more embodiments, the first pixel electrode PE1 and the second pixel electrode PE2 may be formed through the same process. The first pixel electrode PE1 and the second pixel electrode PE2 may include crystalline indium tin oxide.

The intermediate electrodes CTE may include a first intermediate electrode CTE1 and a second intermediate electrode CTE2 that extend in the second direction DR2.

The first intermediate electrode CTE1 may be provided and/or formed both on the respective second ends EP2 of the first light emitting elements LD1, and on the first insulating layer INS1 over the third alignment electrode ALE3. In a plan view, the first intermediate electrode CTE1 may have a shape extending in the second direction DR2 between the first pixel electrode PE1 and the second pixel electrode PE2.

The second intermediate electrode CTE2 may be provided and/or formed both on the respective first ends EP1 of the second light emitting elements LD2, and on the first insulating layer INS1 over the fourth alignment electrode ALE4. In a plan view, the second intermediate electrode CTE2 may have a shape extending in the second direction DR2 between the second pixel electrode PE2 and the first bank BNK1 located in the non-emission area NEMA. The first intermediate electrode CTE1 and the second intermediate electrode CTE2 may be integrally provided and connected with each other. The first intermediate electrode CTE1 and the second intermediate electrode CTE2 may be respectively different areas of the intermediate electrode CTE.

In one or more embodiments, the first intermediate electrode CTE1 and the second intermediate electrode CTE2 may be formed through the same process. The first intermediate electrode CTE1 and the second intermediate electrode CTE2 may include indium zinc oxide, and may be designed to have thicknesses that is greater than that of the first and second pixel electrodes PE1 and PE2.

The first pixel electrode PE1, the second pixel electrode PE2, and the intermediate electrode CTE may be spaced apart from each other in a plan view. The first pixel electrode PE1 may face one area of the intermediate electrode CTE, for example, the first intermediate electrode CTE1. The first pixel electrode PE1 and the first intermediate electrode CTE1 may extend in the same direction, for example, in the second direction DR2, and may be spaced apart from each other in the first direction DR1. The second pixel electrode PE2 may face another area of the intermediate electrode CTE, for example, the second intermediate electrode CTE2. The second pixel electrode PE2 and the second intermediate electrode CTE2 may extend in the second direction DR2, and may be spaced apart from each other in the first direction DR1.

In one or more embodiments, the first pixel electrode PE1 and the first intermediate electrode CTE1 may face each other with the first light emitting elements LD1 provided therebetween. The first pixel electrode PE1 may be directly located on respective one ends (for example, the respective first ends EP1) of the first light emitting elements LD1. The first intermediate electrode CTE1 may be directly located on respective remaining ends (for example, the respective second ends EP2) of the first light emitting elements LD1. Because the first pixel electrode PE1 including crystalline indium tin oxide fixes the respective first ends EP1 of the first light emitting elements LD1, and the first intermediate electrode CTE1 that includes indium zinc oxide and that has a thickness that is greater than the first pixel electrode PE1 fixes the respective second ends EP2 of the first light emitting elements LD1, the first light emitting elements LD1 may be stably located at the aligned positions without being removed therefrom.

Furthermore, in one or more embodiments, the second pixel electrode PE2 and the second intermediate electrode CTE2 may face each other with the second light emitting elements LD2 provided therebetween. The second pixel electrode PE2 may be directly located on respective one/first ends (for example, the respective second ends EP2) of the second light emitting elements LD2. The second intermediate electrode CTE2 may be directly located on respective remaining/second ends (for example, the respective first ends EP1) of the second light emitting elements LD2. Because the second pixel electrode PE2 including crystalline indium tin oxide fixes the respective second ends EP2 of the second light emitting elements LD2, and the second intermediate electrode CTE2 that includes indium zinc oxide and that has a thickness greater than the second pixel electrode PE2 fixes the respective first ends EP1 of the second light emitting elements LD2, the second light emitting elements LD2 may be stably located at the aligned positions without being removed therefrom.

The plurality of first light emitting elements LD1 may be connected in parallel with each other between the first pixel electrode PE1 and the first intermediate electrode CTE1, and may form the first serial set SET1. The plurality of second light emitting elements LD2 may be connected in parallel with each other between the second intermediate electrode CTE2 and the second pixel electrode PE2, and may form the second serial set SET2.

Although in the foregoing embodiments there has been described that the first pixel electrode PE1 and the second pixel electrode PE2 include crystalline indium tin oxide, and the first intermediate electrode CTE1 and the second intermediate electrode CTE2 include indium zinc oxide, the present disclosure is not limited thereto. In one or more embodiments, the opposite case is also possible. For example, the first intermediate electrode CTE1 and the second intermediate electrode CTE2 may include crystalline indium tin oxide, and the first pixel electrode PE1 and the second pixel electrode PE2 may include indium zinc oxide, and may be designed to have a thickness that is greater than that of the first and second intermediate electrodes CTE1 and CTE2.

As described above, in the emission area EMA of each pixel PXL, respective one/first ends of the light emitting elements LD may be fixed by one electrode including crystalline indium tin oxide, and respective remaining/second ends of the light emitting elements LD may be fixed by another electrode including transparent conductive material, for example, indium zinc oxide, which is different from that of the respective/second one electrodes. Consequently, the light emitting elements LD may be stably fixed without using a separate fixing component (for example, an insulating pattern) for fixing the light emitting elements LD. Hence, a process of forming the separate fixing component may be omitted, so that the efficiency of the process of fabricating the pixel PXL (or the display device) may be improved.

In a display device and a method of fabricating the display device in accordance with embodiments, a light emitting element may be directly fixed by a first electrode (or a first pixel electrode) and a second electrode (or a second pixel electrode) that are formed of different conductive materials. Consequently, a separate structure (or an insulating pattern) for fixing the light emitting element may be omitted, so that the efficiency of a fabricating process may be enhanced.

The effects of the present disclosure are not limited by the foregoing, and other various effects are anticipated herein.

While various embodiments have been described above, those skilled in the art will appreciate that various modifications, additions and substitutions are possible, without departing from the scope of the present disclosure.

Therefore, the embodiments disclosed in this specification are only for illustrative purposes, rather than limiting the technical scope of the present disclosure. The scope of the present disclosure must be defined by the accompanying claims, with functional equivalents thereof to be included therein.

## Claims

1. A display device comprising:
a substrate comprising a pixel area comprising an emission area and a non-emission area; and
a pixel in the pixel area, and comprising:
a light emitting element comprising a first end and a second end that face each other;
a first electrode on, and electrically connected to, the first end of the light emitting element; and
a second electrode on, and electrically connected to, the second end of the light emitting element, and comprising a different conductive material than, and having a different thickness than, the first electrode.

2. The display device according to claim 1, wherein the first electrode comprises crystalline indium tin oxide, and
wherein the second electrode comprises indium zinc oxide.

3. The display device according to claim 2, wherein a thickness of the second electrode is greater than a thickness of the first electrode.

4. The display device according to claim 3, wherein the first electrode comprises amorphous indium tin oxide before the second electrode is on the second end of the light emitting element.

5. The display device according to any one of claims 2 to 4, wherein the first electrode and the second electrode are spaced from each other, and
wherein the light emitting element is between the first electrode and the second electrode.

6. The display device according to claim 5, wherein the first electrode directly contacts the first end of the light emitting element, and
wherein the second electrode directly contacts the second end of the light emitting element, optionally wherein the first electrode and the second electrode directly fix the light emitting element.

7. The display device according to claim 1, wherein the first electrode comprises indium zinc oxide, and
wherein the second electrode comprises crystalline indium tin oxide, optionally wherein a thickness of the first electrode is greater than a thickness of the second electrode.

8. The display device according to any one of claims 2 to 7, wherein the pixel comprises:
a first bank pattern and a second bank pattern above the substrate, and spaced from each other;
a first insulating layer above the first and the second bank patterns, and configured to cover the first and the second bank patterns;
a first bank on the first insulating layer in the non-emission area, and defining a first opening corresponding to the emission area, and a second opening spaced from the first opening;
a first alignment electrode below the first insulating layer and over the first bank pattern in the emission area, and electrically connected with the first electrode; and
a second alignment electrode below the first insulating layer and over the second bank pattern in the emission area, and electrically connected with the second electrode.

9. The display device according to claim 8, wherein the first insulating layer defines a first contact hole that exposes a portion of the first alignment electrode, and a second contact hole that exposes a portion of the second alignment electrode,
wherein the first electrode is electrically connected to the first alignment electrode through the first contact hole, and
wherein the second electrode is electrically connected to the second alignment electrode through the second contact hole.

10. The display device according to claim 8 or claim 9, wherein the pixel further comprises an auxiliary insulating layer between the first electrode and the second electrode, and
wherein the auxiliary insulating layer is on the first electrode, covers the first electrode, and overlaps a portion of the second electrode, optionally wherein the auxiliary insulating layer fixes the light emitting element.

11. The display device according to any one of claims 8 to 10, wherein:
(i) the pixel comprises:
a color conversion layer above the first electrode and the second electrode in the emission area, and configured to convert a first color of light emitted from the light emitting element to a second color of light;
a second bank above the first bank in the non-emission area, and configured to at least partially enclose the color conversion layer; and
a color filter above the color conversion layer, and configured to allow the second color of light to selectively pass therethrough; and/or
(ii) the pixel further comprises at least one transistor above the substrate, and electrically connected to the light emitting element.

12. The display device according to any one of claims 8 to 11, wherein the pixel comprises:
a third alignment electrode between the first alignment electrode and the second alignment electrode, and spaced apart from the first and the second alignment electrodes;
a fourth alignment electrode adjacent to the second alignment electrode, and spaced apart from the first to the third alignment electrodes;
a first intermediate electrode spaced apart from the first and the second electrodes, and above the third alignment electrode; and
a second intermediate electrode spaced apart from the first and the second electrodes, and above the fourth alignment electrode.

13. The display device according to claim 12, wherein the light emitting element comprises:
a first light emitting element electrically connected to the first electrode and the first intermediate electrode; and
a second light emitting element electrically connected to the second intermediate electrode and the second electrode,
wherein the first end of the first light emitting element is electrically connected to the first electrode, and the second end of the first light emitting element is electrically connected to the first intermediate electrode, and
wherein the first end of the second light emitting element is electrically connected to the second intermediate electrode, and the second end of the second light emitting element is electrically connected to the second electrode.

14. A method of fabricating a display device, the method comprising forming, above a substrate, at least one pixel comprising an emission area and a non-emission area by:
forming, above the substrate in the emission area, a first alignment electrode and a second alignment electrode spaced apart from each other;
forming a first insulating layer on the first and the second alignment electrodes;
forming a first bank, which defines an opening corresponding to the emission area, on the first insulating layer in the non-emission area;
aligning light emitting elements on the first insulating layer between the first alignment electrode and the second alignment electrode in the emission area;
forming a first electrode electrically connected to respective first ends of the light emitting elements and the first alignment electrode; and
forming a second electrode electrically connected to respective second ends of the light emitting elements and the second alignment electrode, the second electrode comprising a different conductive material than, and having a different thickness than, the first electrode.

15. The method according to claim 14, wherein forming the first electrode comprises:
applying a conductive layer comprising amorphous indium tin oxide to surfaces of the light emitting elements and the first insulating layer;
forming a conductive pattern by locating a mask over the conductive layer and performing a photolithography process, the conductive pattern overlapping a portion of the first insulating layer and the respective first ends of the light emitting elements; and
forming the first electrode comprising crystalline indium tin oxide by crystallizing the amorphous indium tin oxide by performing a heat treatment process on the conductive pattern, optionally wherein the method further comprises forming an auxiliary insulating layer covering the conductive pattern after forming the conductive pattern.
